(19) Europäisches Patentamt
European Patent Office
Office européen des brevets

(11) EP 4 651 180 A1

(12) **EUROPEAN PATENT APPLICATION**
published in accordance with Art. 153(4) EPC

(43) Date of publication:
**19.11.2025 Bulletin 2025/47**

(21) Application number: **25746538.5**

(22) Date of filing: **05.03.2025**

(51) International Patent Classification (IPC):
***H01L 21/02*** (2006.01) ***B32B 7/12*** (2006.01)
***B32B 9/00*** (2006.01) ***B32B 37/12*** (2006.01)

(86) International application number:
**PCT/JP2025/008048**

(87) International publication number:
**WO 2025/204650 (02.10.2025 Gazette 2025/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **29.03.2024 JP 2024056811**

(71) Applicant: **DAIKIN INDUSTRIES, LTD.**
**Osaka-Shi, Osaka 530-0001 (JP)**

(72) Inventors:
- **NAKAGAWA, Chihiro**
  **Osaka-shi, Osaka 530-0001 (JP)**
- **OHMUKAI, Yoshikage**
  **Osaka-shi, Osaka 530-0001 (JP)**
- **HOSODA, Kazuki**
  **Osaka-shi, Osaka 530-0001 (JP)**
- **NAMIKAWA, Takashi**
  **Osaka-shi, Osaka 530-0001 (JP)**

(74) Representative: **Hoffmann Eitle**
**Patent- und Rechtsanwälte PartmbB**
**Arabellastraße 30**
**81925 München (DE)**

(54) **METHOD FOR PRODUCING LAMINATE, AND LAMINATE**

(57) A method for producing a layered product including two silicon substrates, comprising:
(a) providing a first silicon substrate having a first electrically conductive region on at least a part of the surface, and a second silicon substrate; and
(b) bonding a surface including the first electrically conductive region of the first silicon substrate to the second silicon substrate with an adhesive layer,
wherein the adhesive layer includes, on a first activated region provided by activating at least a part of the surface including the first electrically conductive region of the first silicon substrate, a first reaction product derived from a first organic material reactable with the first activated region, and
the layered product has electric conductivity.

[Fig. 1A]

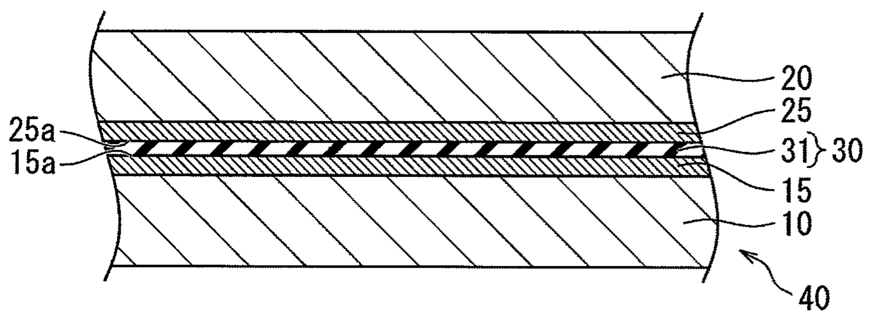


EP 4 651 180 A1

## Description

### Technical Field

The present invention relates to a method for producing a layered product and a layered product.

### Background Art

In the field of semiconductor technology, for example, in Patent Literature 1, providing an adhesive layer between silicon substrates has been studied as a method for bonding two silicon substrates.

### Citation List

### Patent Literature

Patent Literature 1: WO 2023/276638 A1

### Summary of Invention

### Technical Problem

An object of the present disclosure is to provide a novel layer product and a production method thereof.

### Solution to Problem

In order to solve the problem, the present disclosure provides the following [1] to [23].

[1] A method for producing a layered product including two silicon substrates, comprising:

(a) providing a first silicon substrate having a first electrically conductive region on at least a part of the surface, and a second silicon substrate; and
(b) bonding a surface including the first electrically conductive region of the first silicon substrate to the second silicon substrate with an adhesive layer,

wherein the adhesive layer includes, on a first activated region provided by activating at least a part of the surface including the first electrically conductive region of the first silicon substrate, a first reaction product derived from a first organic material reactable with the first activated region, and
the layered product has electric conductivity.

[2] The production method according to [1], wherein the first electrically conductive region includes a metal.
[3] The production method according to [2], wherein the metal in the first electrically conductive region is at least one selected from the group consisting of Cu, Co, Fe, Al, W, Ru and Hf.
[4] The production method according to any one of [1] to [3], wherein the surface of the first electrically conductive region is exposed.
[5] The production method according to any one of [1] to [3], wherein at least a part of the surface of the first electrically conductive region is in contact with the adhesive layer.
[6] The production method according to any one of [1] to [5], wherein the adhesive layer includes two or more layers.
[7] The production method according to any one of [1] to [6],

wherein the first activated region is provided in at least a part of the first electrically conductive region and at least a part of the first silicon substrate;
the first electrically conductive region includes at least one selected from the group consisting of Cu, Co, Fe, Al, W, Ru and Hf;
the adhesive layer is in contact with the first activated region; and
the adhesive layer has a thickness of 5 nm or less.

[8] The production method according to any one of [1] to [7],

wherein, further, the second silicon substrate has a second electrically conductive region on at least a part of the surface; and
the adhesive layer is provided on a second activated region provided by activating at least a part of the surface of the second silicon substrate on a side of the second electrically conductive region, and includes a second reaction product derived from a second organic material.

[9] The production method according to [8], wherein the second electrically conductive region includes a metal.
[10] The production method according to [8] or [9], wherein the metal in the second electrically conductive region is at least one selected from the group consisting of Cu, Co, Fe, Al, W, Ru and Hf.
[11] The production method according to any one of [8] to [10], wherein the surface of the second electrically conductive region is exposed.
[12] The production method according to any one of [8] to [11], wherein at least a part of the surface of the second electrically conductive region is in contact with the adhesive layer.
[13] The production method according to any one of [8] to [12], wherein the distance between the first electrically conductive region and the second electrically conductive region is 5 nm or less.
[14] The production method according to any one of [1] to [13], wherein the adhesive layer has a thickness of 5 nm or less.
[15] The production method according to any one of [8] to [14],

wherein the first activated region is provided in at least a part of the first electrically conductive region and at least a part of the first silicon substrate;
the second activated region is provided in at least a part of the second electrically conductive region and at least a part of the second silicon substrate;
the first electrically conductive region and the second electrically conductive region each include at least one selected from the group consisting of Cu, Co, Fe, Al, W, Ru and Hf;
the adhesive layer is in contact with the first activated region and the second activated region; and
the distance between the first electrically conductive region and the second electrically conductive region is 5 nm or less.

[16] A layered product comprising:

a first silicon substrate having a first electrically conductive region on at least a part of the surface;
a second silicon substrate located on the side of a surface having the first electrically conductive region of the first silicon substrate; and
an adhesive layer that is located between the first silicon substrate and the second silicon substrate and that bonds the surface having the first electrically conductive region of the first silicon substrate to the second silicon substrate,
wherein there is conductivity between the first silicon substrate and the second silicon substrate.

[17] The layered product according to [16],

wherein the second silicon substrate has a second electrically conductive region on at least a part of the surface, and
the adhesive layer bonds the surface having the first electrically conductive region to the surface having the second electrically conductive region.

[18] The layered product according to [17], wherein the distance between the first electrically conductive region and the second electrically conductive region is 5 nm or less.
[19] The layered product according to any one of [16] to [18], wherein the adhesive layer has a thickness of 5 nm or less.
[20] The layered product according to any one of [16] to [19], wherein the adhesive layer includes two or more layers.
[21] The layered product according to any one of [17] to [20],

wherein the layered product has the first electrically conductive region and the second electrically conductive region;
the distance between the first electrically conductive region and the second electrically conductive region is 5 nm or less; and
the adhesive layer bonds the surface having the first electrically conductive region to the surface having the

second electrically conductive region.

[22] The layered product according to any one of [16] to [21], wherein an electric conductivity measured at the adhesive layer provided on the first silicon substrate is in the range of $1.0\times10^{-2}$ to $5.0\times10^{2}$ pA.
[23] The layered product according to any one of [16] to [22], having a resistivity in the range of $1.5\times10^{-8}$ to $2.0\times10^{5}$ $\Omega\cdot$m.

Advantageous Effects of Invention

According to the present disclosure, a novel layered product and a production method thereof can be provided.

Brief Description of Drawings

[Figure 1A] Figure 1A is a schematic cross-sectional diagram showing a part of a layered product in a first embodiment.
[Figure 1B] Figure 1B is a schematic cross-sectional diagram showing a part of a layered product in a first embodiment.
[Figure 1C] Figure 1C is a schematic cross-sectional diagram showing a part of a layered product in a first embodiment.
[Figure 2] Figure 2 is a schematic cross-sectional diagram showing a part of a layered product in a second embodiment.
[Figure 3] Figure 3 is a schematic cross-sectional diagram showing a part of a layered product in a modified example.

Description of Embodiments

Embodiments of the present disclosure will be described in detail below with reference to drawings, though the present disclosure is not limited thereto.

<First embodiment>

Figure 1A, Figure 1B and Figure 1C are schematic cross-sectional diagrams showing a part of a layered product 40 in a first embodiment. As shown in Figure 1A, Figure 1B and Figure 1C, the layered product 40 has a first silicon substrate 10 and a second silicon substrate 20. As shown in Figure 1A and Figure 1C, an adhesive layer 30 is located between the first silicon substrate 10 and the second silicon substrate 20. As shown in Figure 1A and Figure 1C, the first electrically conductive region 15 and the second electrically conductive region 25 are bonded through the adhesive layer 30.

As shown in Figure 1A to Figure 1C, the layered product 40 can be obtained by a production method including the following steps:

(a) providing a first silicon substrate 10 having a first electrically conductive region 15 on at least a part of the surface, and a second silicon substrate 20; and
(b) bonding a surface of the first silicon substrate 10 on a side of the first electrically conductive region 15 to the second silicon substrate 20 with an adhesive layer 30;
wherein the adhesive layer 30 includes a first reaction product derived from a first organic material reactable with the first activated region 15a, on a first activated region 15a provided by activating at least a part of the surface including the first electrically conductive region 15 of the first silicon substrate 10.

Through the structure described above, a novel base can be provided.

In the following, each step is described. In the following, unless otherwise specified, "on first silicon substrate 10" may mean a state in direct contact with the first silicon substrate 10, or a state including another layer or the like on the first silicon substrate 10. The same applies to other substrates, layers or regions.

[Step a]

A first silicon substrate 10 having a first electrically conductive region 15 on at least a part of the surface, and a second silicon substrate 20 are prepared.

(First and second silicon substrates 10 and 20)

The first and second silicon substrates 10 and 20 (hereinafter collectively also referred to simply as "silicon substrate") may be a silicon-based substrate (or a base) and may be made of silicon or may contain any other appropriate substance in addition to silicon. Examples of the substance include a dopant, impurities that may be inevitably mixed, metal (e.g., electrodes, wiring and vias), an oxide, nitride and/or carbide of silicon or the like (e.g., a dielectric layer, insulating layer and protecting layer).

The first silicon substrate 10 and the second silicon substrate 20 may have the same structure or different structure. In an aspect, the first silicon substrate 10 and the second silicon substrate have the same structure. In an aspect, the first silicon substrate 10 and the second silicon substrate have a structure different from each other.

The first silicon substrate 10 may have a first bonding part in the surface. The second silicon substrate 20 may have a second bonding part in the surface. The first bonding part and the second bonding part are also collectively referred to simply as "bonding part".

(First and second bonding parts)

In the present embodiment, the bonding part needs only to be a portion containing silicon oxide (hereinafter also referred to as "silicon oxide portion"). The silicon oxide portion may be made of silicon oxide or may include any other suitable substances in addition to silicon oxide. Examples of the other substances include a dopant and impurities that may be inevitably mixed.

The bonding part can be formed, for example, by oxidizing the whole or a part of the surface of a silicon substrate (typically, one of the two surfaces of silicon substrate facing each other) (i.e., surface treatment). In other words, the first bonding part may constitute the whole of the surface of the first silicon substrate 10 (typically, one of the two surfaces of the silicon substrate 10 facing each other), or may constitute a region as a part thereof. The second bonding part may include the whole of the surface of the second silicon substrate 20 (typically, one of the two surfaces of the silicon substrate 20 facing each other), or may include a region as a part thereof.

Oxidation of silicon may be performed by heating in an atmosphere containing oxygen (so-called thermal oxidation) and/or by natural oxidation. Alternatively, for example, the bonding part of the present embodiment may be formed by depositing silicon oxide on the entire surface or a partial region of the surface of a silicon substrate (typically, one of the two surfaces of silicon substrates facing each other). The deposition of silicon oxide may be performed by any one of sputtering, chemical vapor deposition (CVD), plasma enhanced chemical vapor deposition (PECVD), vapor deposition, or by any combination of two or more thereof. Alternatively, a combination of oxidation of silicon and deposition of silicon oxide may be performed. However, the method for forming the bonding part as silicon oxide portion is not limited thereto, and it may be formed by any suitable method.

On the surface of the bonding part as silicon oxide portion, at least some of silanol groups (-Si-OH) are definitely present.

The thickness of the bonding part is not limited as long as the layered product finally produced achieves desired or acceptable characteristics. For example, each of the thickness of the bonding part, which is a part made of silicon oxide, can be 1 nm or more and 1 $\mu$m or less, particularly 10 nm or less. The thickness of the bonding part may be measured, for example, by using a cross section scanning electron microscope (cross section SEM) or SEM, specifically by using SEM.

(First and second electrically conductive regions 15 and 25)

As shown in Figure 1A and Figure 1B, the first and second electrically conductive regions 15 and 25 are regions through which electricity passes easily, preferably regions that contain metal and are provided in at least a part of the first and second silicon substrates 10 and 20. The first and second electrically conductive regions 15 and 25 are, for example, regions that contain an electrically conductive metal. Examples of the metal include preferably at least one selected from the group consisting of Cu, Co, Fe, Al, W, Ru and Hf, more preferably Cu. The first electrically conductive region 15 may contain the same metal as in the second electrically conductive region 25, or may contain a different metal.

The first and second electrically conductive regions 15 and 25 are formed, for example, by chemical vapor deposition (CVD) (for example, thermal CVD, plasma CVD and the like), physical vapor deposition (PVD) (for example, vacuum vapor deposition, sputtering and the like), atomic layer deposition (ALD), or plating (for example, electroplating, electroless plating, hot-dip plating and the like).

The electric conductivity may be measured, for example, by scanning spreading resistance microscopy (SSRM). For example, the numerical value of electric conductivity may be an average of the current values obtained by SSRM.

The first electrically conductive region 15 may be provided, for example, in a range of 1 to 50% relative to the surface of the first silicon substrate 10. The second electrically conductive region 25 may be provided, for example, in a range of 1 to 50% relative to the surface of the second silicon substrate 20.

In the case where the first silicon substrate 10 has a first bonding part, the first electrically conductive region 15 is provided on the same surface as of the first bonding part. In this case, the first bonding part may be provided first, and then the first electrically conductive region 15 may be provided; the first electrically conductive region 15 may be provided first, and then the first bonding part may be provided; or the first electrically conductive region 15 and the first bonding part may be provided at the same time. The first electrically conductive region 15 and the first bonding part may be overlapped partly. In other words, after provision of the first bonding part on the first silicon substrate 10, the first electrically conductive region 15 may be provided in at least a part of the first bonding part.

In the case where the second silicon substrate 20 has the second bonding part, the second electrically conductive region 25 is provided on the same surface as of the second bonding part. In this case, the second bonding part may be provided first, and then the second electrically conductive region 25 may be provided; the second electrically conductive region 25 may be provided first, and then the second bonding part may be provided; or the second electrically conductive region 25 and the second bonding part may be provided at the same time. The second electrically conductive region 25 and the second bonding part may be overlapped partly. In other words, after provision of the second bonding part on the second silicon substrate 20, the second electrically conductive region 25 may be provided in at least a part of the second bonding part.

(First and second activated regions 15a and 25a)

Though not necessarily required in the present embodiment, a first activated region 15a may be provided on the first silicon substrate 10, and a second activated region 25a may be provided on the second silicon substrate 20.

The first activated region 15a is a region in which at least a part of the surface of the first silicon substrate 10 and/or at least a part of the surface of the first electrically conductive region 15 are activated. The first activated region 15a is formed by, for example, subjecting a surface including the first electrically conductive region 15 to at least one processing selected from the group consisting of hydrogen atom processing, heat treatment in a hydrogen-containing atmosphere, sputtering, chemical vapor deposition (CVD), and terminal treatment using a chemical solution. Thereby, H or OH is bonded to the first electrically conductive region 15. In an aspect, the first activated region 15a is formed in a part of the first electrically conductive region 15. In an aspect, the first activated region 15a is formed on the whole surface of the first electrically conductive regions 15. In the case where a plurality of first electrically conductive regions 15 are present on the first silicon substrate 10, the first electrically conductive region 15 may not be formed on a part of the first activated region 15a. In other words, a first electrically conductive region 15 having no first activated region 15a may be present.

The second activated region 25a is a region in which at least a part of the surface of the second silicon substrate 20 and/or at least a part of the surface of the second electrically conductive region 25 are activated. The second activated region 25a is formed in the same manner as in the first activated region 15a. In an aspect, the second activated region 25a is formed in a part of the second electrically conductive region 25. In an aspect, the second activated region 25a is formed on the whole surface of the second electrically conductive regions 25. In the case where a plurality of second electrically conductive regions 25 are present on the second silicon substrate 20, the second electrically conductive region 25 may not be formed on a part of the second activated region 25a. In other words, a second electrically conductive region 25 having no second activated region 25a may be present.

In an embodiment, after the step (a) and before the step (b), at least one of the first bonding part and the second bonding part may be subjected to surface treatment for generation of a hydrosilyl group and/or a silanol group to provide a first activated region 15a and/or second activated region 25a. Thereby, hydrosilyl groups (-Si-H) and/or silanol groups (-Si-OH) can be present at a higher density on the surface of the bonding part. The surface treatment may be performed on the surface of the bonding part (bonding surface), and may be performed on the surface of the bonding part only or on a wider surface including the surface of the bonding part. The concentrations of the hydrosilyl group and silanol group on the surface of the bonding part may be measured, for example, from the peak intensity in time-of-flight secondary ion mass spectrometry (TOF-SIMS), or by using X-ray photoelectron spectrometry (XPS). The surface treatment may be performed before providing the first and second electrically conductive regions 15 and 25.

The surface treatment to produce hydrosilyl groups and/or silanol groups may be at least one selected from the group consisting of hydrogen atom treatment, heat treatment in a hydrogen-containing atmosphere, sputtering treatment, chemical vapor deposition treatment (CVD), and terminal treatment with a chemical solution. By the hydrogen atom treatment, heat treatment in a hydrogen-containing atmosphere, sputtering treatment, CVD, or terminal treatment with a chemical solution, hydrogen atoms can be introduced on the surface of the bonding part to produce hydrosilyl groups (-Si-H). By the terminal treatment with a chemical solution, hydroxyl groups can be introduced on the surface of the bonding part to produce silanol groups (-Si-OH).

The hydrogen atom treatment may be performed, for example, by supplying hydrogen gas at about $1\times10^{-4}$ Pa into a vacuum chamber at an ultra-high vacuum ($1\times10^{-6}$ Pa or less), and dissociating hydrogen molecules into hydrogen atoms by thermal electrons or plasma, so that hydrogen atoms are adsorbed on the surface of the bonding part.

The heat treatment in a hydrogen-containing atmosphere may be performed, for example, by flowing hydrogen

as a carrier gas during evacuation to replace the atmosphere in the chamber with hydrogen gas to create a vacuum state of a hydrogen atmosphere (specifically, hydrogen atmosphere at 10 Pa or less), and heating the substrate to about 100 to 400°C in the atmosphere, so that hydrogen is adsorbed on the surface of the bonding part.

The sputtering treatment may be performed, for example, by using silicon as sputtering source, and supplying hydrogen to be adsorbed on the surface of the bonding part.

The CVD treatment may be performed, for example, by using silane as CVD gas, and adjusting the gas pressure of hydrogen such that hydrogen atoms are adsorbed on the surface of the bonding part.

The terminal treatment with a chemical solution may be performed, for example, by immersing a silicon substrate in a chemical solution such as hydrofluoric acid aqueous solution (hydrofluoric acid) or a chemical solution of ammonium fluoride with at least the bonding part exposed, such that hydrogen ions and/or hydroxide ions are bound to the surface of the bonding part depending on the chemical solution used.

In an embodiment, after the step (a) and before the step (b), at least one of the first bonding part and the second bonding part may be subjected to surface treatment for generation of a fluorosilyl group to provide a first activated region 15a and/or second activated region 25a. The surface treatment may be performed before providing the first and second electrically conductive regions 15 and 25.

The surface treatment to produce fluorosilyl groups may be at least one selected from the group consisting of CVD, discharge treatment, ion implantation, and terminal treatment with a chemical solution. The surface treatment to produce fluorosilyl groups may be performed separately or simultaneously with the surface treatment to produce hydrosilyl groups and/or silanol groups. In the case of a separate treatment, any one of the surface treatments may be performed first.

The CVD treatment may be performed using, for example, $CF_4$ and/or $SF_6$ as CVD gas to adsorb fluorine atoms onto the surface of the bonding part.

The discharge treatment may be performed, for example, by plasma discharging or corona discharging in an atmosphere containing $CF_4$ and/or $SF_6$ to adsorb fluorine radicals on the surface of the bonding part.

The ion implantation may be performed by implanting fluorine ions into the bonding part by any suitable method.

The terminal treatment with a chemical solution may be performed, for example, by immersing a silicon substrate in a chemical solution such as hydrofluoric acid aqueous solution (hydrofluoric acid) or a chemical solution of ammonium fluoride with at least the bonding part exposed, such that fluorine ions are bound to the surface of the bonding part depending on the chemical solution used. In particular, the terminal treatment with a hydrofluoric acid aqueous solution allows hydrosilyl groups (-Si-H), silanol groups (-Si-OH), and fluorosilyl groups (-Si-F) to be produced.

The first silicon substrate 10 and the second silicon substrate 20 are provided as described above.

[Step b]

Next, a surface including the first electrically conductive region 15 of the first silicon substrate 10 and the second silicon substrate 20 are bonded with the adhesive layer 30.

In the case where the second silicon substrate 20 includes the second electrically conductive region 25, the distance between the first electrically conductive region 15 and the second electrically conductive region 25, i.e. the distance between the surface of the first electrically conductive region 15 on a side of the second electrically conductive region 25 and the surface of the second electrically conductive region 25 facing the first electrically conductive region 15 on a side of the first electrically conductive region 15, is preferably 5 nm or less, more preferably 3 nm or less, and, for example, may be 2 nm or less, or 1 nm or less. The lower limit of the distance between the first electrically conductive region 15 and the second electrically conductive region 25 is not limited, and for example, 0.2 nm or more.

When the distance between the first electrically conductive region 15 and the second electrically conductive region 25 is small, the electric conductivity between the electrically conductive regions becomes better. When the distance is larger, the adhesive layer 30 generally becomes a nonconductor, so that the first electrically conductive region 15 and the second electrically conductive region 25 are mutually insulated.

The distance may be measured, for example, by using an ellipsometer.

The adhesive layer 30 includes a reaction product derived from a first organic material reactable with the first activated region 15a, on the first activated region 15a provided by activating at least a part of the surface including the first electrically conductive region 15 of the first silicon substrate 10.

As shown in Figure 1A, at least a part of the surface of the first activated region 15a on the opposite side of the first silicon substrate 10 is in contact with the adhesive layer 30. At least a part of the surface of the second activated region 25a on the opposite side of the second silicon substrate 20 is in contact with the adhesive layer 30.

As shown in Figure 1B, on the surface of the first activated region 15a, the adhesive layer 30 may be absent and a void space 60 may be present; while on the surface of the second activated region 25a, the adhesive layer 30 may be absent and a void space 60 may be present. In other words, the surfaces of the first and second activated regions 15a and 25a may be exposed.

Although the first activated region 15a faces the second activated region 25a in Figure 1A and Figure 1B, another

region or the like may be faced. For example, the first activated region 15a may be faced to the second silicon substrate 20, the first activated region 15a may be faced to the second bonding part, the second activated region 25a may be faced to the second silicon substrate 20, or the second activated region 25a may be faced to the first bonding part.

(Adhesive layer 30)

The adhesive layer 30 has a first adhesive part 31. The adhesive layer 30 (first adhesive part 31) includes a first reaction product derived from an organic material.

As shown in Figure 1A and Figure 1B, the adhesive layer 30 is provided on at least a part of the first and second activated regions 15a and 25a. In this case, the adhesive layer 30 may cause a chemical reaction with the first and second activated regions 15a and 25a, or may be simply in contact with them.

Preferably, the adhesive layer 30 is joined to at least a part of the first and second activated regions 15a and 25a, or causes a chemical reaction with it. The organic material may cause a reaction with the first activated region 15a and no reaction with the second activated region 25a to be bonded, or may cause a reaction with the second activated region 25a and no reaction with the first activated region 15a to be bonded.

As shown in Figure 1C, the adhesive layer 30 may be in direct contact with the first and second silicon substrates 10 and 20. Although the first silicon substrate 10 is faced to the second silicon substrate 20 in Figure 1C, a different substrate, region or the like may be faced. For example, the first silicon substrate 10 may be faced to the second activated region 25a, the first silicon substrate 10 may be faced to the second bonding part, the second silicon substrate 20 may be faced to the first activated region 15a, or the second silicon substrate 20 may be faced to the first bonding part.

The adhesive layer 30 may be provided in at least a part of the first electrically conductive region 15. When seen from the direction vertical to the first electrically conductive region 15 (first silicon substrate 10), the adhesive layer 30 may cover the whole of the first activated region 15a and further at least a part of the first electrically conductive region 15, or may cover a part of the first activated region 15a without being provided on the first electrically conductive region 15 (in other words, the whole surface of the first electrically conductive region 15 is exposed). In other words, the surface of the first electrically conductive region 15 may be exposed, or at least a part thereof may be in contact with the adhesive layer 30.

The adhesive layer 30 may be provided in at least a part of the second electrically conductive region 25. When seen from the direction vertical to the first electrically conductive region 15 (second silicon substrate 20), the adhesive layer 30 may cover the whole of the second activated region 25a and further at least a part of the second electrically conductive region 25, or may cover a part of the second activated region 25a without being provided on the second electrically conductive region 25 (in other words, the whole surface of the second electrically conductive region 25 is exposed). In other words, the surface of the second electrically conductive region 25 may be exposed, or at least a part thereof may be in contact with the adhesive layer 30.

The adhesive layer 30 is provided on the first bonding part and may react with the first bonding part. The adhesive layer 30 is provided further on the second bonding part and may react with the second bonding part. Thereby, the adhesive layer 30 bonds the first bonding part to the second bonding part. A part of the first bonding pat may be exposed, or the whole of the first bonding part may be covered with the adhesive layer 30. Also, a part of the second bonding pat may be exposed, or the whole of the second bonding part may be covered with the adhesive layer 30.

The adhesive layer 30 (first adhesive part 31) may include, for example, two or more layers. In other words, an adhesive part as the first layer is provided on the first silicon substrate 10, dried and/or heated on an as needed basis, and then an adhesive layer as the second layer may be provided. The number of layers of the adhesive part is not limited, and may be 5 or less.

The thickness of the adhesive layer 30 (for example, the distance between the first activated region 15a and the second activated region 25a) may be extremely thin. The thickness of the adhesive layer 30 is, for example, 10 nm or less, and may be, in particular, 8 nm or less, 5 nm or less, 3 nm or less, or 1.5 nm or less. The lower limit of the thickness of the adhesive layer 30 is not limited, and may be, for example, 1 nm or more. Due to a thickness of the adhesive layer 30 in the range, the distance between the first electrically conductive region 15 and the second electrically conductive region 25 decreases, so that the electric conductivity between the electrically conductive regions can be ensured. Since the adhesive layer 30 generally conducts no electricity, the first electrically conductive region 15 and the second electrically conductive region 25 are mutually insulated with increased thickness. The thickness of the adhesive layer 30 may be measured, for example, by using cross-sectional SEM, SEM or an ellipsometer, specifically may be measured by using high-speed mapping spectroscopic ellipsometer (theta-SE).

The amount of particles contained in the surface on the opposite side of the first silicon substrate 10 of the first adhesive part 31 is preferably 0 piece/$mm^2$ or less. The measurement of the amount of particles may be performed as follows. A composition is disposed on a substrate separately prepared, then the composition is dried, and the surface after drying is subjected to the measurement.

The amount of particles may be measured, for example, by using a surface foreign matter detector. The

measurement may be performed, for example, in an inspection range of 300 mm×300 mm.

With an amount of the particles in the range, good adhesion strength between the first silicon substrate 10 and the second silicon substrate 20 is obtained. Further, the layered product 40 can be produced at a relatively low temperature, so that the occurrence of voids in the adhesive layer 30 can be effectively suppressed or prevented. The adhesion strength may be measured, for example, by using an ultrasonic microscope.

The particle may be a single particle or may be an aggregate of particles. In other words, the particle includes a primary particle and a secondary particle. Further, the particle may be made of inorganic substance or organic substance. Examples of the particle include one that exists in a particle shape after curing of organic material, such as a particle that exists in the environment and a particle that is supplied together with the organic material.

The particle size of a particle means light-scattering equivalent size that can be quantitatively determined by a measurement device. The particle size can be measured, for example, by using a surface foreign matter inspecting device or a liquid particle counter. The particle size can be measured, for example, by using a surface foreign matter inspecting device, under conditions limiting to 60 nm or more.

The lower limit of the amount of particles is, for example, 0 piece/$mm^2$ or more, though not limited. The particle size of the particle is, for example, 200 nm or more. The upper limit of the particle size of the particle may be, for example, 6 μm or less, though not limited.

Although the first adhesive part 31 is provided on the first bonding part in the first embodiment, the first adhesive part 31 may be provided on the second bonding part. In this case, "first bonding part" is deemed to be replaced with "second bonding part".

(Organic material)

The organic material is a material reactable with a hydrosilyl group and/or silanol group. The organic material has at least two functional groups. It is preferable that the two functional groups be located at both terminal parts of the organic material.

The functional group at one terminal part of the organic material reacts with the first activated region 15a, so that a reaction product is formed. In other words, the structure of the reaction product depends on the construction of the organic material.

The functional group at another terminal parts of the organic material is reactable with the second activated region 25a. Through the reaction product derived from the organic material, the first silicon substrate 10 and the second silicon substrate 20 are bonded.

In the case where the first silicon substrate 10 has a first bonding part, the organic material is reactable with the first bonding part. In the case where the second silicon substrate 20 has a second bonding part, the organic material is reactable with the second bonding part. Due to having the structure described above, the adhesion strength between the first silicon substrate 10 and the second silicon substrate 20 can be improved.

Preferably, the amount of particles in the organic material is 500 pieces/mL or less. The lower limit value of the amount of particles in the organic material may be, for example, 0 piece/mL or more, though not limited thereto. The amount of particles in the organic material may be measured, for example, by using a syringe sampling system SLS-1040.

Preferably, purification by filtering the organic material is included. Thereby, the particles included in the organic material are removed, so that the amount of particles included in the first adhesive part 31 can be reduced.

The organic material may be used, for example, as the composition including a solvent and the like. The composition may include a solvent and a reaction accelerator such as acid/base catalyst, other than the organic material. As the solvent, one that is usually used may be used, and for example, propylene glycol monomethyl ether acetate, propylene glycol monomethyl ether, toluene, tetrahydrofuran, or isopropyl alcohol may be used. The water content in the composition is substantially zero. With such a low water content in the composition, the occurrence of voids can be reduced.

The composition may be prepared by dissolving, dispersing or suspending an organic material in a solvent. For example, the composition is prepared by dissolving an organic material.

The amount of particles in the composition is, for example, 500 pieces/mL or less. The lower limit of the amount of particles in the composition is, for example, 0 piece/mL or more, though not limited thereto.

Preferably, purification of the composition by filtering is included. Thereby, particles included in the composition is removed, so that the amount of particles included in the first adhesive part 31 can be reduced.

Preferably, the filtering is performed by using a membrane having an effective diameter of 100 nm or less. The effective diameter of the membrane is more preferably 50 nm or less, still more preferably 10 nm or less. The lower limit of the effective diameter of the membrane may be, for example, 1 nm or more, though not limited thereto. The effective diameter means the average value of the effective diameters of a membrane.

The specific aspect of the methods for supplying and bonding the organic material (or the composition containing the organic material) may be appropriately selected depending on the organic material for use. Schematically, after

supplying the organic material to the first bonding part, the first silicon substrate 10 and the second silicon substrate 20 are maintained under specified reaction conditions (at specified temperature, in particular), with the organic material lying between the first silicon substrate 10 and the second silicon substrate 20, thereby the reaction may proceed. The organic material may be supplied to the second boding part instead of the first bonding part.

For example, an organic material (which may be a composition) is applied (for example, by applying, spraying, printing, etc.) to one or both of the surface on the side having the first electrically conductive region 15 of the first silicon substrate 10 (the surface having the first activated region 15a in at least a part thereof) and the surface on the side having the second electrically conductive region of the second silicon substrate (the surface having the second activated region 25a in at least a part thereof). The organic material may be applied directly or in the form of a composition mixed with any suitable component (e.g., solvent). Washing and/or drying may be then performed on an as needed basis. The same washing and drying as described above may be applied, and in the case of using an organic material containing fluorine, pre-washing with a fluorine-based solvent may be performed.

Then, the first silicon substrate 10 and the second silicon substrate 20 are aligned such that the first electrically conductive region 15 faces to the second electrically conductive region 25. Thereby, the first silicon substrate 10 is closely contacted to the second silicon substrate 20 through the organic material. The first silicon substrate 10 and the second silicon substrate 20 that are closely contacted to each other are maintained under specific conditions (specific temperature, in particular), so that a reaction proceeds during this period. Then, annealing may be performed on an as needed basis.

As another example, after supplying an organic material (or a composition containing an organic material) to the surface on the side having the first electrically conductive region 15 (the surface having the first activated region 15a in at least a part thereof), the first silicon substrate 10 and the second silicon substrate 20 are maintained under specified reaction conditions (at specified temperature, in particular), with the organic material lying between the first electrically conductive region 15 and the second electrically conductive region 25, thereby the first silicon substrate 10 and the second silicon substrate 20 may be bonded with a reaction product.

In an aspect, in the case where an organic material is applied to the surface of the first electrically conductive region 15, after washing the surface of the layer formed of the organic material with water or water-containing organic solvent, the second electrically conductive region 25 may be disposed on the layer. The organic material may be applied to the surface of the second electrically conductive region 25 instead of the surface of the first electrically conductive region 15.

The functional group of the organic material has at least one selected from the group consisting of, for example, an alkenyl group, a hydroxyl group, a hydrolyzable silyl group, an isocyanate group, an epoxy group, an amino group, an acid anhydride group and a siloxane bond. An alkenyl group is reactive with a hydrosilyl group (-Si-H), and a hydroxyl group, a hydrolyzable silyl group, an isocyanate group, an epoxy group, an amino group, an acid anhydride group and a siloxane bond are reactive with a silanol group (-Si-OH).

More specifically, the organic material may include at least one selected from the group consisting of the following (i) to (iv). As the organic material, one compound may be used or a combination of two or more compounds may be used. In the following, the reaction between an organic material and the first and second activated regions 15a and 25a, or the reaction between an organic material and the first and second bonding parts are described, though a reaction of other combinations may be included. For example, an organic material may react with the first activated region 15a and the second bonding part, and an organic material may react with the second activated region 25a and the first bonding part.

(i) A substituted or unsubstituted hydrocarbon compound having an alkenyl group at two terminal parts.
(ii) A substituted or unsubstituted hydrocarbon compound having an alkenyl group at a terminal part, and any one selected from the group consisting of a hydroxy group, a hydrolyzable silyl group, an isocyanate group, an epoxy group, an amino group, and an acid anhydride group at the other terminal part.
(iii) A substituted or unsubstituted hydrocarbon compound having any one selected independently from a hydroxyl group, a hydrolyzable silyl group, an isocyanate group, an epoxy group, an amino group, a phosphate group, and an acid anhydride group at two terminal parts.
(iv) Silsesquioxane and a derivative thereof.

Exemplary aspects in which the organic materials (i) to (iv) are used are described in the following.

· Usage example of organic material (i)

(First example)

In this example, on a part of the surface of the first silicon substrate 10 and the second silicon substrate 20, the first and second electrically conductive regions 15 and 25 are formed. The first and second electrically conductive regions are

at least partly activated to have the first and second activated regions 15a and 25a. The first and second activated regions 15a and 25a may have, for example, hydrogen atoms on the surface.

Further, the first silicon substrate 10 and the second silicon substrate 20 may have a first bonding part and a second bonding part (in the present example, a silicon oxide part). One having a hydrosilyl group (-Si-H) on the surface of the first and second bonding parts may be used. The first silicon substrate 10 and the second silicon substrate 20 that have a hydrosilyl group on the surface of the first bonding part and the second bonding part, which are made of silicon oxide, may be obtained, for example, by surface treatment that generates the hydrosilyl group described above.

As the organic material, a substituted or unsubstituted hydrocarbon compound having an alkenyl group at both terminal parts is used. The alkenyl group is a reactive group to a hydrogen atom in the activated region and/or a hydrosilyl group in the bonding part. Such a compound may have two or more terminal parts and may have an alkenyl group at any two or more terminal parts. Such a compound may be fluorine-substituted, or in other words, may be a fluoroalkyl compound or a fluoropolyether group-containing compound having an alkenyl group at two or more terminal parts.

For example, fluoroalkyl compounds having an alkenyl group at 2, 3 or 4 ends are shown in the following. Rf represents a fluoroalkyl group (the same hereinafter). Incidentally, in the following compounds, for example, the alkenyl group may be bonded to a different carbon atom included in Rf.

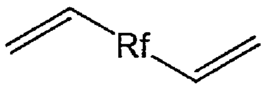 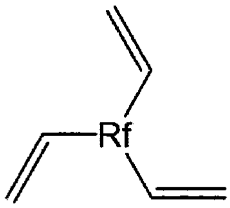 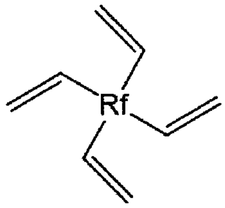

The number of carbons in a part excluding the reactive group at a terminal part (alkenyl group) may be, for example, 1 or more and 200 or less, and 100 or less, in particular, though not limited thereto. The number of carbons may be, for example, 5 or more. The portions excluding the reactive groups may be in a linear, branched or cyclic form. In the case where the portion excluding the reactive groups at terminals is a fluoroalkyl group, which may be, for example, a perfluoroalkyl group without limitations on the fluorine substitution ratio.

The fluoropolyether group-containing compound having an alkenyl group at two or more terminal parts may be, for example, a compound represented by

(A) Formula (1):

$$R^D_\gamma\text{-}X^A\text{-}R^{F2}\text{-}X^A\text{-}R^D_\gamma \qquad (1)$$

wherein $R^{F2}$ is $-Rf^2_p-R^F-O_q-$;
$Rf^2$ is a $C_{1-20}$ alkylene group optionally substituted with one or more fluorine atoms;
$R^F$ are each independently groups represented by the following formula at each occurrence:

$$-(OC_6F_{12})_a-(OC_5F_{10})_b-(OC_4F_8)_c-(OC_3R^{Fa}{}_6)_d-(OC_2F_4)_e-(OCF_2)_f-$$

wherein $R^{Fa}$ are each independently a hydrogen atom, a fluorine atom, or a chlorine atom at each occurrence, a, b, c, d, e and f are each independently an integer of 0 to 200, the sum of a, b, c, d, e and f is 1 or more, and the order of presence of each repeating unit bracketed and subscripted with a, b, c, d, e or f is arbitrary in the formula, provided that in the case all $R^{Fa}$ are hydrogen atoms or chlorine atoms, at least one of a, b, c, e and f is one or more;
p is 0 or 1;
q is 0 or 1;
$R^D$ is $CH_2$=CH-;
$X^A$ are each independently a single bond or a divalent to decavalent organic group;
$\gamma$ are each independently an integer of 1 to 9; or

(B) Formula (2):

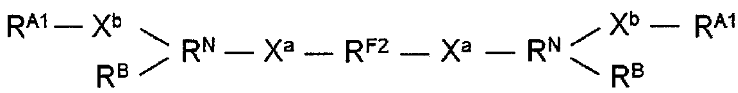 (2)

wherein $R^N$ is:

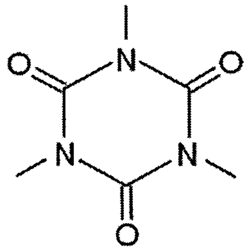

, or

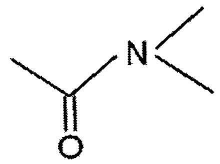

$R^{F2}$ is $-Rf^2{}_p-R^F-O_q-$;

$Rf^2$ is a $C_{1-6}$ alkylene group optionally substituted by one or more fluorine atoms;

$R^F$ are each independently a group represented by the following formula at each occurrence:

$$-(OC_6F_{12})_a-(OC_5F_{10})_b-(OC_4F_8)_c-(OC_3R^{Fa}{}_6)_d-(OC_2F_4)_e-(OCF_2)_f-$$

wherein $R^{Fa}$ are each independently a hydrogen atom, a fluorine atom, or a chlorine atom at each occurrence, a, b, c, d, e and f are each independently an integer of 0 to 200, the sum of a, b, c, d, e and f is 1 or more, the order of presence of each repeating unit bracketed and subscripted with a, b, c, d, e or f is arbitrary in the formula, and provided that in the case all $R^{Fa}$ are hydrogen atoms or chlorine atoms, at least one of a, b, c, e and f is one or more;

p is 0 or 1;

q is 0 or 1;

$X^a$ are each independently a single bond or a divalent organic group at each occurrence;

$R^{A1}$ are each independently an $OR^{Ac}$ group-containing group at each occurrence;

$R^{Ac}$ is a (meth)acryloyl group;

$R^B$ are each independently $R^{F1}-X^a-$ or $R^{A1}-X^b-$ at each occurrence;

$R^{F1}$ is $Rf^1-R^F-O_q-$;

$Rf^1$ is a $C_{1-16}$ alkyl group optionally substituted by one or more fluorine atoms, and

$X^b$ is a divalent organic group. Incidentally, in $R^N$ on the left side in the formula, any of the linking groups may bond to $X^a$, and on the right side in the formula, the left side bonds to $X^a$ and the right side bonds to $X^b$ or $R^B$. Further, in $R^F$, the sum of a, b, c, d, e and f may be, for example, 5 or more.

The organic material is supplied between the first silicon substrate 10 and the second silicon substrate 20 to cause a reaction. The organic material may react with the first and second activated regions 15a and 25a. Specifically, the alkenyl group of the organic material may react with each of the hydrogen atoms of the first and second activated regions 15a and 25a. Further, in the case where the first and second silicon substrates 10 and 20 have the first and second bonding parts, respectively, the alkenyl group of the organic material may react with the hydrosilyl groups of the first bonding part and the second bonding part (hydrosilylation). Thereby, the reaction product derived from the organic material chemically bonds to the metals of the first and second activated regions 15a and 25a and/or Si atoms of the first and second bonding parts. According to the reaction, no by-product is generated, so that the problem of formation of voids derived from by-products can be fundamentally eliminated.

The reaction may be performed once with the organic material sandwiched between the first silicon substrate 10 and the second silicon substrate 20, or may be performed in two separate times by applying the organic material on any one of the first silicon substrate 10 and the second silicon substrate 20 for partial proceeding of the reaction, and then disposing another one on top of the organic material for further proceeding of the reaction.

An exemplary reaction with use of a fluoroalkyl compound having alkenyl groups at two terminal parts is shown as follows. Incidentally, in the following, Cu is described as an example of the first and second electrically conductive regions 15 and 25. The same applies to a fluoropolyether group-containing compound having alkenyl groups at two terminal parts.

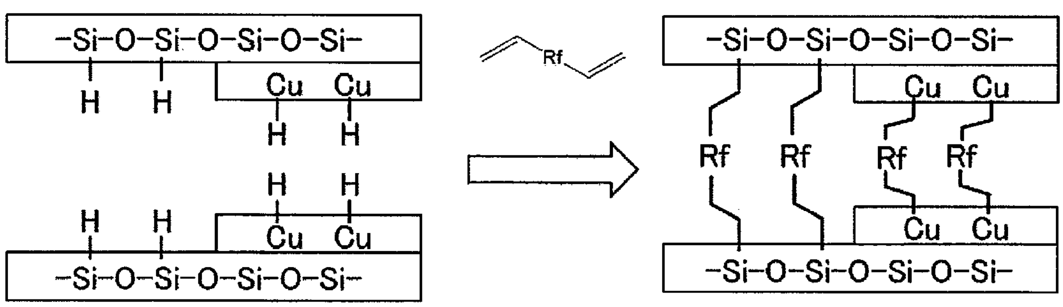

As shown in the schematic drawing described above, the first reaction product derived from the organic material chemically bonds to both of the metal atom of the first electrically conductive region 15 and the metal atom of the second electrically conductive region 25. However, it is not required that all of the reaction products chemically bond to both of the metal atom of the first electrically conductive region 15 and the Si atom of the second electrically conductive region 25. A part of the reaction products may chemically bond to any of the metal atom of the first electrically conductive region 15 and the metal atom of the second electrically conductive region 25 only, or may chemically bond to two or more metal atoms. In order to achieve higher bonding strength, it is preferable that a larger number of reaction products chemically bond to both of the metal atom of the first electrically conductive region 15 and the metal atom of the second electrically conductive region 25. From the viewpoint, it is preferable that the organic material be a straight-chain compound having an alkenyl group at both terminal parts, though not limited thereto.

The first reaction product derived from the organic material is chemically bound to both of the Si atoms of the first bonding part and the Si atoms of the second bonding part. However, not all of the reaction products need to be chemically bound to both of the Si atoms of the first bonding part and the Si atoms of the second bonding part. Some of the reaction products may be chemically bound only to any one of the Si atoms of the first bonding part or the Si atoms of the second bonding part, or chemically bound to two or more Si atoms in the same silicon substrate. In order to obtain higher bonding strength, it is preferable that more reaction products be chemically bound to both of the Si atoms of the first bonding part and the Si atoms of the second bonding part.

Though not shown in the schematic drawing, the first reaction product derived from the organic material may include bonding between the Si atom of the first or second bonding part and the metal atom of the first or second electrically conductive region 15 or 25.

From the viewpoint, it is preferable that the organic material be a straight-chain compound having an alkenyl group at both terminal parts, though not limited thereto.

Further, the first reaction product may bond to both of the metal atom of the first electrically conductive region 15 and the metal atom of the second electrically conductive region 25 only, without bonding to the Si atom of the first or second bonding part. In the following examples, the first reaction product may bond to metal atom only without bonding to Si atom in the same manner.

(Second example)

In the first example, through chemical reactions between the first and second silicon substrates 10 and 20, and between the first and second electrically conductive regions 15 and 25, the first reaction product bonds the both. In the second example, between the first and second electrically conductive regions 15 and 25, there exists a part A unreacted with the first and second electrically conductive regions 15 and 25, so that no chemical reaction occurs between the first and second electrically conductive regions 15 and 25 and the part A, which is different from the first example. In other words, the first and second electrically conductive regions 15 and 25 are not chemically bonded through the part A.

Apart from that, the structure is the same as in the first example. For example, between the first and second silicon substrates 10 and 20, there exists a first reaction product, which causes a chemical reaction with the surface of the first and second silicon substrates 10 and 20 to bond both. Thereby, the bonding strength between the first and second silicon substrates 10 and 20 is improved.

The first and second electrically conductive regions may be at least partly activated to have the first and second activated regions 15a and 25a, or may have none of the first and second activated regions 15a and 25a.

For example, in the case of using a fluoroalkyl compound having an alkenyl group at two terminal parts as shown in the schematic drawing, a chemical reaction proceeds in the first and second bonding parts in the same manner as in the first example.

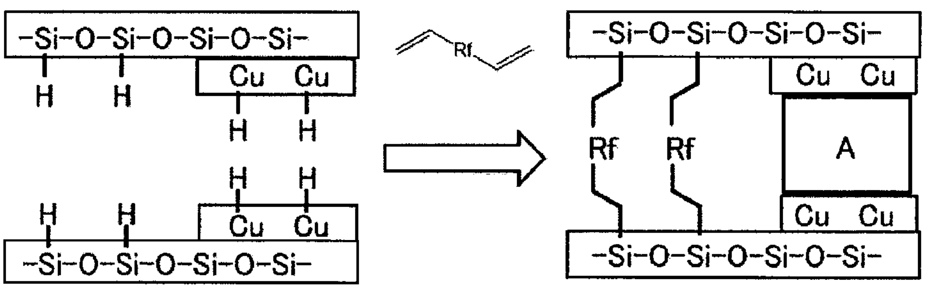

The part A exists between the metal atom in the first electrically conductive region 15 and the metal atom in the second electrically conductive region 25. The part A is located in at least a part of the first and second electrically conductive regions 15 and 25. No reaction is caused with the metal atom of the first electrically conductive region 15 and

the second electrically conductive region 25. The whole surfaces of the first electrically conductive region 15 and the second electrically conductive region 25 may have the part A, or only a part thereof may have the part A, and other parts may have no part A.

The part A may include an organic compound unreacted with the metal atom of the first electrically conductive region 15 and the second electrically conductive region 25 (hereinafter referred to as "unreacted organic compound"). The unreacted organic compound is preferably an electrically conductive compound. The electrical conductivity of the part A may be, for example, in the range of $1.0\times10^{-2}$ to $5.0\times10^{2}$ pA.

The part A may include, for example, an oil or the like. Examples of the oil include a (non-reactable) fluoro (poly) ether compound comprehended as fluorine-containing oil, preferably a perfluoro (poly)ether compound (hereinafter referred to as "fluorine-containing oil").

Examples of the fluorine-containing oil include a compound represented by the following general formula (I) (perfluoro (poly)ether compound):

$$Rf^5\text{-}(OC_4F_8)_{a'}\text{-}(OC_3F_6)_{b'}\text{-}(OC_2F_4)_{c'}\text{-}(OCF_2)_{d'}\text{-}Rf^6 \ ... \qquad (I)$$

In the formula, $Rf^5$ represents an alkyl group having 1 to 16 carbon atoms, which may be substituted with 1 or more fluorine atoms (preferably a $C_{1-16}$ perfluoroalkyl group); $Rf^6$ represents an alkyl group having 1 to 16 carbon atoms, which may be substituted with 1 or more fluorine atoms (preferably a $C_{1-16}$ perfluoroalkyl group), a fluorine atom or a hydrogen atom; and more preferably, $Rf^5$ and $Rf^6$ are each independently a $C_{1-3}$ perfluoroalkyl group.

In the formula, a', b', c' and d' represent the number of four types of repeating units of perfluoro (poly)ether that constitutes the backbone of a polymer, respectively, which are each independently an integer of 0 or more and 300 or less, and the sum of a', b', c' and d' is at least 1, preferably 1 to 300, more preferably 20 to 300. The occurrence order of the respective repeating units in parentheses with subscripts a', b', c' and d' is arbitrary in the formula. Among the repeating units, - $(OC_4F_8)$- may be any of -$(OCF_2CF_2CF_2CF_2)$-, - $(OCF(CF_3)CF_2CF_2)$-, -$(OCF_2CF(CF_3)CF_2)$-, - $(OCF_2CF_2CF(CF_3))$-, - $(OC(CF_3)_2CF_2)$-, -$(OCF_2C(CF_3)_2)$-, -$(OCF(CF_3)CF(CF_3))$-, - $(OCF(C_2F_5)CF_2)$- and -$(OCF_2CF(C_2F_5))$-, and preferably - $(OCF_2CF_2CF_2CF_2)$-. -$(OC_3F_6)$- may be any of - $(OCF_2CF_2CF_2)$-, - $(OCF(CF_3)CF_2)$- and -$(OCF_2CF(CF_3))$-, and preferably - $(OCF_2CF_2CF_2)$-. -$(OC_2F_4)$- may be any of -$(OCF_2CF_2)$- and - $(OCF(CF_3))$-, and preferably -$(OCF_2CF_2)$-.

Examples of the perfluoro (poly)ether compound represented by the general formula (I) include a compound represented by any of the following general formula (Ia) and (Ib) (which may include one compound or a mixture of two or more).

$$Rf^5\text{-}(OCF_2CF_2CF_2)_{b''}\text{-}Rf^6 \ ... \qquad (Ia)$$

$$Rf^5\text{-}(OCF_2CF_2CF_2CF_2)_{a''}\text{-}(OCF_2CF_2CF_2)_{b''}\text{-}(OCF_2CF_2)_{c''}\text{-}(OCF_2)_{d''}\text{-}Rf^6 \ ... \qquad (Ib)$$

In the formulas, $Rf^5$ and $Rf^6$ are as described above; in the formula (Ia), b" is an integer of 1 or more and 100 or less; in the formula (Ib), a" and b" each independently an integer of 1 or more and 30 or less, c" and d" are each independently an integer of 1 or more and 300 or less. The occurrence order of the respective repeating units in parentheses with subscripts a'', b'', c" and d" is arbitrary in the formula.

The fluorine-containing oil may have a number average molecular weight of 1,000 to 30,000. In particular, it is preferable that the number average molecular weight of the compound represented by the formula (Ia) be 2,000 to 8,000. In an aspect, the number average molecular weight of the compound represented by the formula (Ib) is 3,000 to 8,000. In another aspect, the number average molecular weight of the compound represented by the formula (Ib) is 8,000 to 30,000.

From another point of view, the fluorine-containing oil may be a compound represented by a general formula Rf'-F (in the formula, Rf' is a $C_{5-16}$ perfluoroalkyl group). Alternatively, the fluorine-containing oil may be a chlorotrifluoroethylene oligomer. The compound represented by Rf'-F and the chlorotrifluoroethylene oligomer are preferred, due to having high affinity with the perfluoro (poly)ether group-containing silane compound, of which Rf is $C_{5-16}$ perfluoro (poly)ether group.

The part A may include a void, or may have a void only. In other words, a void may be present between the first electrically conductive region 15 and the second electrically conductive region 25. Further, an unreacted organic compound included in the part A may be present in another part, specifically between the first and second silicon substrates 10 and 20, for example, between the first and second silicon substrates 10 and 20 bonded with a fluoroalkyl compound.

Also in the following example, the part A may have the same structure.

· Example with use of organic material (ii) (Third example)

In this example, in a part of the surface of a first silicon substrate 10 and a second silicon substrate 20, a first and second electrically conductive regions 15 and 25 are formed. The first and second electrically conductive regions may be

at least partly activated to have the first and second activated regions 15a and 25a. For example, the first activated region 15a may have a hydroxyl group on the surface, and the second activated region 25a may have a hydrogen atom on the surface.

Further, the first silicon substrate 10 and the second silicon substrate 20 may have a first bonding part and a second bonding part (silicon oxide parts in the present example). As the first silicon substrate 10, one having a silanol group (-Si-OH) on the surface of the first bonding part (silicon oxide part in the present example) is used. The first silicon substrate 10 having silanol groups on the surface of the first bonding part as silicon oxide portion requires no particular surface treatment, though the silanol groups may be obtained by the surface treatment to produce silanol groups described above on an as needed basis.

As the organic material, a substituted or unsubstituted hydrocarbon compound having an alkenyl group at one terminal part and a hydroxyl group at the other terminal part is used. The alkenyl group is a reactive group to the hydroxyl group of the first activated region 15a and/or the hydrosilyl group of the first bonding part, and the hydroxyl group is a reactive group to the hydrogen atom of the second activated region 25a and/or the silanol group of the second bonding part. Such a compound may have two or more terminal parts and may have an alkenyl group at any one or more terminal parts and a hydroxyl group at any one or more terminal parts. Such a compound may be fluorine-substituted, or in other words, may be a fluoroalkyl compound or a fluoropolyether group-containing compound having an alkenyl group at one terminal part and a hydroxyl group at the other terminal part.

In addition, unless otherwise specified, the explanations described above may apply. (The same applies as described for the fluoroalkyl compound or fluoropolyether group-containing compound in detail in the (i), except for having a hydroxyl group at least at one terminal.)

The organic material is supplied between the first silicon substrate 10 and the second silicon substrate 20. On this occasion, the organic material is supplied to come into contact with the faced first and second activated regions 15a and 25a. Thereby, the reaction product derived from the first organic material chemically bonds to the metal atom in the first and second activated regions 15a and 25a, so that the first electrically conductive region 15 and the second electrically conductive region 25 are bonded with the reaction product derived from the organic material. Further, the organic material is supplied between the first bonding part and the second bonding part to cause a reaction between the hydroxyl group of the first organic material and the silanol group of the first bonding part (etherification by dehydration) and a reaction between the alkenyl group of the organic material and the hydrosilyl group of the second bonding part (hydrosilylation). Thereby, the reaction product derived from the first organic material is chemically bound to the Si atoms of the first bonding part and the Si atoms of the second bonding part, so that the first bonding part and the second bonding part are bonded by the reaction product derived from the organic material.

More specifically, an organic material is supplied to cause a reaction with the hydroxyl group of the organic material and the hydroxyl group of the first activated region 15a (in first stage). On this occasion, the reaction between the hydroxyl group of the organic material and the silanol group of the first bonding part may be caused. It is preferable that the first electrically conductive region 15 is then faced to the second electrically conductive region 25 to cause the reaction between the hydrogen atom of the second activated region 25a and the alkenyl group of the organic material (in second stage). On this occasion, the reaction between the alkenyl group of the organic material and the hydrosilyl group of the second bonding part may be caused. According to the procedure, water produced as a by-product in the reaction in the first stage can be removed without being trapped between the first silicon substrate 10 and the second silicon substrate 20, and since no by-products are generated in the second-stage reaction, formation of voids derived from the by-products can be avoided.

An exemplary reaction with use of a fluoroalkyl compound having an alkenyl group at one terminal part and a hydroxyl group at the other terminal part is shown in the following. Incidentally, in the following, Cu is described as an example of the first and second electrically conductive regions 15 and 25. Also, in the following, although the reactions only in the first and second activated regions 15a and 25a are described, the reactions may be caused in the first and second bonding parts in the same manner as in the first and second activated regions 15a and 25a. Further, the case of a fluoropolyether group-containing compound having an alkenyl group at one terminal part and a hydroxyl group at the other terminal part is also in the same manner as follows.

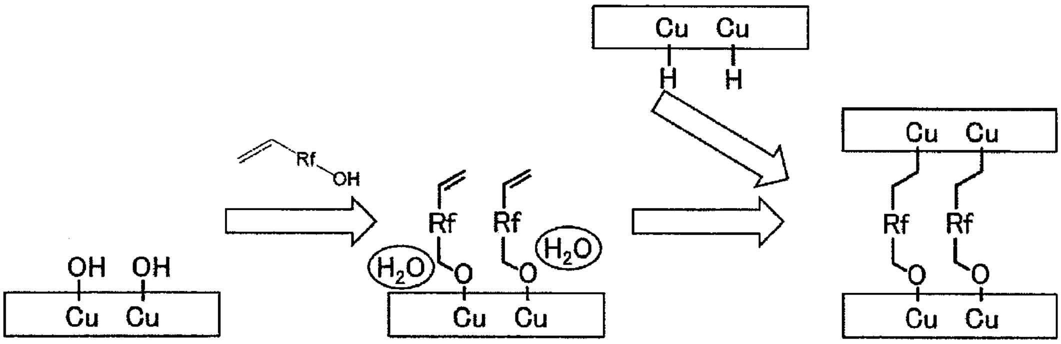

In order to obtain higher bonding strength, the organic material is preferably a linear compound having an alkenyl group and a hydroxyl group at both terminal parts, respectively, though not limited thereto.

Further, according to this example, one having hydroxyl groups in the surface of the first activated region 15a and silanol groups in the surface of the first bonding part is used, and one having hydrogen atoms in the surface of the second activated region 25a and hydrosilyl groups in the surface of the second bonding part is used. Accordingly, in the case of using an organic material having a hydroxy group and an alkenyl group at both terminal parts, respectively (preferably in a straight chain form), chemical bonding of the reaction product to two or more Si atoms in the same silicon substrate can be avoided, so that further higher boding strength can be achieved.

(Fourth example)

In the third example, the organic material causes a chemical reaction with the first and second electrically conductive regions 15 and 25 to connect the first and second electrically conductive regions 15 and 25. The fourth example is different in that the part A is present in at least a part of the surface of the first and second electrically conductive regions 15 and 25, and no chemical reaction occurs between the first and second electrically conductive regions 15 and 25 and the part A. In other words, the first and second electrically conductive regions 15 and 25 are not chemically connected through the part A. Apart from that, the structure is the same as in the example 3, and the part A has the same structure as in the example 2.

Use of a substituted or unsubstituted hydrocarbon compound having an alkenyl group at one terminal part and a hydroxyl group at the other terminal part as the organic material has been described as an example however, instead of/in addition to the hydroxyl group, a substituted or unsubstituted hydrocarbon compound having a hydrolyzable silyl group, an isocyanate group, an epoxy group, an amino group or an acid anhydride group may be used. Any of a hydroxyl group, a hydrolyzable silyl group, an isocyanate group, an epoxy group, an amino group and an acid anhydride group can function as a reactive group for the silanol group. (The substituted or unsubstituted hydrocarbon compound having an alkenyl group at one terminal part and a hydroxyl group at the other terminal part may be the same as a substituted or unsubstituted hydrocarbon compound having hydrolyzable silyl groups at two terminal parts to be described in detail in the following (iii), except for having an alkenyl group at least at one terminal.)

· First example with use of organic material (iii) (Fifth example)

In this example, in a part of the surfaces of the first silicon substrate 10 and the second silicon substrate 20, the first and second electrically conductive regions 15 and 25 are formed. The first and second electrically conductive regions, of which at least a part is activated, have the first and second activated regions 15a and 25a. For example, the first and second activated regions 15a and 25a may have hydroxyl groups on the surface.

Further, the first silicon substrate 10 and the second silicon substrate 20 having silanol groups (-Si-OH) on the surfaces of the first bonding part and the second bonding part (silicon oxide portion in the present example) may be used. The first silicon substrate 10 and the second silicon substrate 20 having silanol groups on the surfaces of the first bonding part and the second bonding part as silicon oxide portions require no particular surface treatment, or may be obtained by the surface treatment to produce silanol groups described above on an as needed basis.

As the organic material, a substituted or unsubstituted hydrocarbon compound having a hydrolyzable silyl group at two terminal parts is used. Such a compound may have two or more terminal parts and may have a hydrolyzable silyl group at any two or more terminal parts. Such a compound may be fluorine-substituted, or in other words, may be a fluorine-containing silane compound such as a fluoroalkyl compound or a fluoropolyether group-containing compound having a hydrolyzable silyl group at two terminal parts.

The fluorine-containing silane compound may be, for example, a compound represented by the following formula (11) :

$$R^{Si}_{\gamma}\text{-}X^{A}\text{-}R^{F2}\text{-}X^{A}\text{-}R^{Si}_{\gamma} \qquad (11)$$

wherein:

$R^{F2}$ is $-Rf^2_p-R^F_r-O_q-$;
$Rf^2$ is a $C_{1-20}$ alkylene group optionally substituted by one or more fluorine atoms;
$R^F$ are each independently a group represented by the following formula at each occurrence:

$$-(OC_6F_{12})_a-(OC_5F_{10})_b-(OC_4F_8)_c-(OC_3R^{Fa}_6)_d-(OC_2F_4)_e-(OCF_2)_f-$$

wherein $R^{Fa}$ are each independently a hydrogen atom, a fluorine atom, or a chlorine atom at each occurrence,
a, b, c, d, e and f are each independently an integer of 0 to 200, the sum of a, b, c, d, e and f is 1 or more; the order of presence of each repeating unit bracketed and subscripted with a, b, c, d, e or f is arbitrary in the formula, and provided that in the case all $R^{Fa}$ are hydrogen atoms or chlorine atoms, at least one of a, b, c, e and f is one or more;
p is 0 or 1;
q is 0 or 1;
r is 0 or 1;
provided that any one of p or r is 1;
$R^{Si}$ is each independently a group represented by the following formulas (S1), (S2), (S3), (S4) or (S5) at each occurrence:

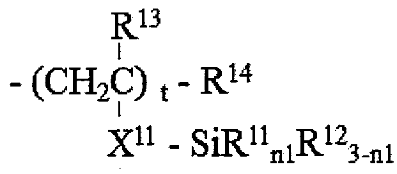

(S1)

$$-SiR^{11}_{n1}R^{12}_{3-n1} \qquad (S2)$$

$$-SiR^{a1}_{k1}R^{b1}_{l1}R^{c1}_{m1} \qquad (S3)$$

$$-CR^{d1}_{k2}R^{e1}_{l2}R^{f1}_{m2} \qquad (S4)$$

$$-NR^{g1}R^{h1} \qquad (S5)$$

wherein:

$R^{11}$ is each independently a hydroxyl group or a hydrolyzable group at each occurrence;
$R^{12}$ is each independently a hydrogen atom or a monovalent organic group at each occurrence;
n1 is each independently an integer of 0 to 3 for each ($SiR^{11}_{n1}R^{12}_{3-n1}$) unit;
$X^{11}$ is each independently a single bond or a divalent organic group at each occurrence;
$R^{13}$ is each independently a hydrogen atom or a monovalent organic group at each occurrence;
t is each independently an integer of 2 or more at each occurrence;
$R^{14}$ is each independently a hydrogen atom, a halogen atom or $-X^{11}-SiR^{11}_{n1}R^{12}_{3-n1}$ at each occurrence;
$R^{a1}$ is each independently $-Z^1-SiR^{21}_{p1}R^{22}_{q1}R^{23}_{r1}$ at each occurrence;
$Z^1$ is each independently an oxygen atom or a divalent organic group at each occurrence;
$R^{21}$ is each independently $-Z^{1'}-SiR^{21'}_{p1'}R^{22'}_{q1'}R^{23'}_{r1'}$ at each occurrence;
$R^{22}$ is each independently a hydroxyl group or a hydrolyzable group at each occurrence;
$R^{23}$ is each independently a hydrogen atom or a monovalent organic group at each occurrence;
p1 is each independently an integer of 0 to 3 at each occurrence;
q1 is each independently an integer of 0 to 3 at each occurrence;
r1 is each independently an integer of 0 to 3 at each occurrence;
$Z^{1'}$ is each independently an oxygen atom or a divalent organic group at each occurrence;
$R^{21'}$ is each independently $-Z^{1''}-SiR^{22''}_{q1''}R^{23''}_{r1''}$ at each occurrence;
$R^{22'}$ is each independently a hydroxyl group or a hydrolyzable group at each occurrence;

$R^{23'}$ is each independently a hydrogen atom or a monovalent organic group at each occurrence;
p1' is each independently an integer of 0 to 3 at each occurrence;
q1' is each independently an integer of 0 to 3 at each occurrence;
r1' is each independently an integer of 0 to 3 at each occurrence;
$Z^{1''}$ is each independently an oxygen atom or a divalent organic group at each occurrence;
$R^{22''}$ is each independently a hydroxyl group or a hydrolyzable group at each occurrence;
$R^{23''}$ is each independently a hydrogen atom or a monovalent organic group at each occurrence;
q1" is each independently an integer of 0 to 3 at each occurrence;
r1" is each independently an integer of 0 to 3 at each occurrence;
$R^{b1}$ is each independently a hydroxyl group or a hydrolyzable group at each occurrence;
$R^{c1}$ is each independently a hydrogen atom or a monovalent organic group at each occurrence;
k1 is each independently an integer of 1 to 3 at each occurrence;
l1 is each independently an integer of 0 to 3 at each occurrence;
m1 is each independently an integer of 0 to 3 at each occurrence;
$R^{d1}$ is each independently $-Z^2-CR^{31}_{p2}R^{32}_{q2}R^{33}_{r2}$ at each occurrence;
$Z^2$ is each independently a single bond, an oxygen atom or a divalent organic group at each occurrence;
$R^{31}$ is each independently $-Z^{2'}-CR^{32'}_{q2'}R^{33'}_{r2'}$ at each occurrence;
$R^{32}$ is each independently $-Z^3-SiR^{34}_{n2}R^{35}_{3-n2}$ at each occurrence;
$R^{33}$ is each independently a hydrogen atom, a hydroxyl group, or a monovalent organic group at each occurrence;
p2 is each independently an integer of 0 to 3 at each occurrence;
q2 is each independently an integer of 0 to 3 at each occurrence;
r2 is each independently an integer of 0 to 3 at each occurrence;
$Z^{2'}$ is each independently a single bond, an oxygen atom or a divalent organic group at each occurrence;
$R^{32'}$ is each independently $-Z^3-SiR^{34}_{n2}R^{35}_{3-n2}$ at each occurrence;
$R^{33'}$ is each independently a hydrogen atom, a hydroxyl group, or a monovalent organic group at each occurrence;
q2' is each independently an integer of 0 to 3 at each occurrence;
r2' is each independently an integer of 0 to 3 at each occurrence;
$Z^3$ is each independently a single bond, an oxygen atom or a divalent organic group at each occurrence;
$R^{34}$ is each independently a hydroxyl group or a hydrolyzable group at each occurrence;
$R^{35}$ is each independently a hydrogen atom or a monovalent organic group at each occurrence;
n2 is each independently an integer of 0 to 3 at each occurrence;
$R^{e1}$ is each independently $-Z^3-SiR^{34}_{n2}R^{35}_{3-n2}$ at each occurrence;
$R^{f1}$ is each independently a hydrogen atom, a hydroxyl group, or a monovalent organic group at each occurrence;
k2 is each independently an integer of 0 to 3 at each occurrence;
l2 is each independently an integer of 0 to 3 at each occurrence;
m2 is each independently an integer of 0 to 3 at each occurrence;
$R^{g1}$ is $R^{h1}$ are each independently $-Z^4-SiR^{11}_{n1}R^{12}_{3-n1}$ , $-Z^4-SiR^{a1}_{k1}R^{b1}_{l1}R^{c1}_{m1}$, or $-Z^4-CR^{d1}_{k2}R^{e1}_{l2}R^{f1}_{m2}$ at each occurrence;
$Z^4$ is each independently a single bond, an oxygen atom or a divalent organic group at each occurrence;
provided that, in formulas (S1), (S2), (S3), (S4) and (S5), at least one Si atom binding to a hydroxyl group or hydrolyzable group is present;
$X^A$ is each independently a single bond or a divalent to decavalent organic group; and
$\gamma$ is each independently an integer of 1 to 9.

The hydrolyzable group means a group that can be subjected to a hydrolysis reaction, preferably $-OR^j$, $-OCOR^j$, $-O-N=CR^j_2$, $-NR^j_2$, $-NHR^j$ or a halogen. $R^j$ is a substituted or unsubstituted $C_{1-4}$ alkyl group, preferably an unsubstituted $C_{1-4}$ alkyl group. The $C_{1-4}$ alkyl group is preferably an ethyl group or a methyl group, more preferably a methyl group.

The simplest hydrolyzable silyl group may be an alkoxysilyl group. The number of alkoxy group in the alkoxysilyl group is 1 or more and 3 or less, and may be, for example, 3. The number of carbon atoms in the alkoxy group may be, for example, 1 or more and 4 or less, particularly 2 or less, and preferably 1.

The unsubstituted silane compound may be, for example, a compound represented by $R^k_3Si-(CH_2)_{n35}-SiR^k_3$. $R^k$ each independently mean a group that may be subjected to a hydrolysis reaction, and preferably each independently are $-OR^j$, $-OCOR^j$, $-O-N=CR^j_2$, $-NR^j_2$, $-NHR^j$ or a halogen. $R^j$ is a substituted or unsubstituted $C_{1-4}$ alkyl group, preferably an unsubstituted $C_{1-4}$ alkyl group. The $C_{1-4}$ alkyl group is preferably an ethyl group or a methyl group, more preferably a methyl group. Further, n35 is an integer of 1 to 18.

Unless otherwise specified, the above explanation may be applied.

The organic material is supplied between the first silicon substrate 10 and the second silicon substrate 20 to

cause a reaction. The organic material may cause a reaction with the first and second activated regions 15a and 25a. Specifically, the alkenyl group of the organic material and the hydrogen atoms in the first and second activated regions 15a and 25a each may cause a reaction. Also, the organic material may be supplied between the first bonding part and the second bonding part to cause a reaction between the hydrolyzable silyl group of the organic material and the silanol groups of the first bonding part and the second bonding part (for example, in the case where the hydrolyzable group is an alkoxy group, a siloxane bond is formed through dealcoholization). Thereby, the first reaction product derived from the organic material chemically bonds to the metals in the first and second electrically conductive regions 15 and 25 and/or Si atoms in the first and second bonding part. As the by-product in such a reaction, for example, an alcohol is produced. The alcohol has only a small number of carbon atoms as described above, and can be removed to the outside effectively through openings of the reaction product between the first silicon substrate 10 and the second silicon substrate 20, so that the formation of voids derived from by-products can be reduced.

The organic material may be provided on the first activated region 15a to cause a reaction between both of them. Then, after washing of the surface of the layer formed from the organic material with water or a water-containing organic solvent, the second activated region 25a may be disposed on the layer. Thereby, the hydrolyzable silyl group present on the surface is transformed into silanol, so that formation of by-products such as hydrolyzable silyl group or voids derived from by-products can be suppressed. Alternatively, the organic material may be applied to the surface of the second activated region 25a instead of the surface of the first activated region 15a.

The reaction may be performed once with the organic material sandwiched between the first silicon substrate 10 and the second silicon substrate 20, or may be performed in two separate times by applying the organic material on any one of the first silicon substrate 10 and the second silicon substrate 20 for partial proceeding of the reaction, and then disposing another one on top of the organic material for further proceeding of the reaction.

An exemplary reaction with use of an alkyl compound having a trimethoxysilyl group at two terminal parts is shown as follows. In the following, an exemplary reaction performed in two separate times as described above is also shown. Incidentally, as an example of the first and second electrically conductive regions 15 and 25, Cu is described in the following. Although only the reactions in the first and second activated regions 15a and 25a are described in the following, the reactions may occur also in the first and second bonding parts in the same manner as in the first and second activated regions 15a and 25a.

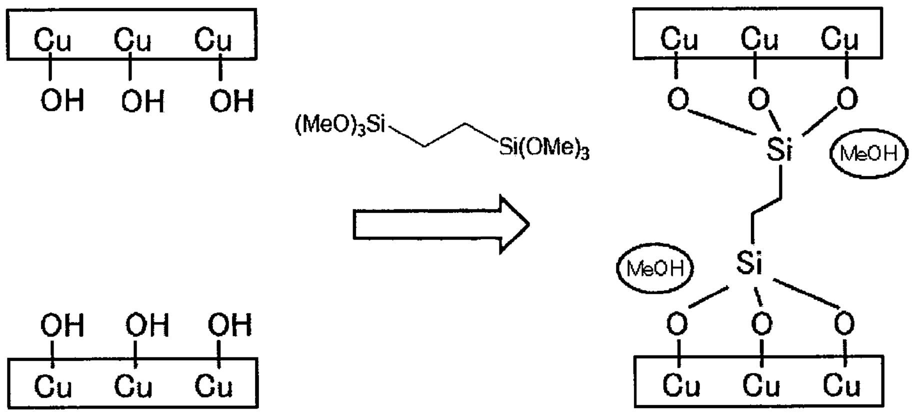

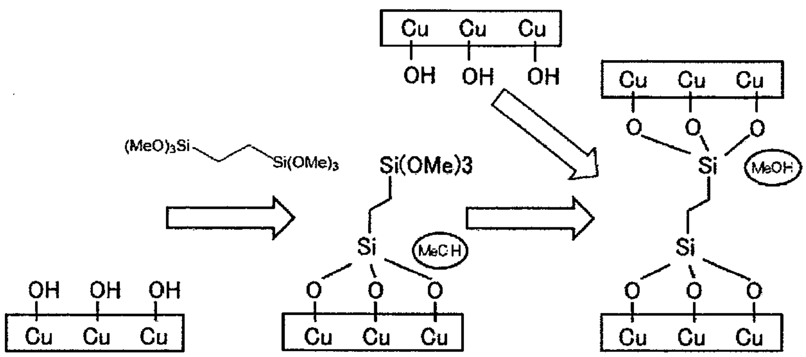

In order to obtain higher bonding strength, the organic material is preferably a linear compound having a hydrolyzable silyl group at both terminal parts, though not limited thereto.

· Second example using organic material (iii) (Sixth example)

In the example, differences from the first example using the organic material (iii) described above will be mainly explained, and unless otherwise specified, the explanations described in the first example may be applied.

As the organic material, a substituted or unsubstituted hydrocarbon compound having an isocyanate group at two terminal parts is used. The compound may have two or more terminal parts, and may have an isocyanate group at any two or more terminal parts.

The organic material is supplied between the first silicon substrate 10 and the second silicon substrate 20, such that an isocyanate group of the organic material reacts with the hydroxyl group in the first and second activated regions 15a and 25a. Thereby, the first reaction product derived from the organic material chemically bonds to the metal atoms in the first and second electrically conductive regions 15 and 25, so that the first electrically conductive region 15 and the second electrically conductive region 25 are bonded with the reaction product derived from the organic material. Further, a reaction of the isocyanate group of the organic material with the silanol group of the first bonding part and the second bonding part may be caused (formation of urethane bond). Thereby, the first reaction product derived from the organic material is chemically bound to the Si atoms of the first bonding part and the Si atoms of the second bonding part, so that the first bonding part and the second bonding part are bonded by the first reaction product derived from the first organic material. According to the reaction, no by-products are generated, so that the problem of formation of voids derived from by-products can be fundamentally eliminated.

The unsubstituted silane compound may be, for example, a compound represented by $OCN-(CH_2)_{n35}-NCO$. Incidentally, n35 is an integer of 1 to 18.

As an aspect, a reaction with use of an alkyl compound having an isocyanate group at two terminal parts is shown in the following. In the following, Cu is described as an example of the first and second electrically conductive regions 15 and 25. Also, in the following, although the reactions only in the first and second activated regions 15a and 25a are described, the reactions may be caused in the first and second bonding parts in the same manner as in the activated regions 15a and 25a. In the present aspect, in common with an alkyl compound having a trimethoxysilyl group at two terminal parts, one of the isocyanate groups only may cause the reaction first, and then another isocyanate group may cause the reaction.

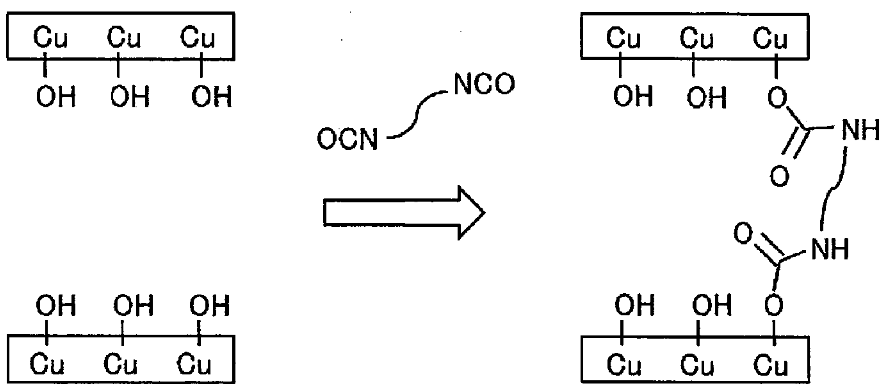

As another aspect, a reaction with use of a compound having a phosphate group is shown in the following. In the following, although $CH_3PO(OH)_2$ is used as an example of the compound having a phosphate group, other compounds having a different constitution with inclusion of a phosphate group may be used. For example, a compound having two or more phosphate groups such as 1,6-hexane diphosphonate may be used. In the case of a compound having two or more phosphate groups, one of the phosphate groups may react with the first electrically conductive region 15 and another phosphate group may react with the second electrically conductive region 25.

In the following, Cu is described as an example of the first and second electrically conductive regions 15 and 25. In the following, although the reactions only in the first and second activated regions 15a and 25a are described, the reactions may be caused also in the first and second bonding parts in the same manner as in the first and second activated regions 15a and 25a.

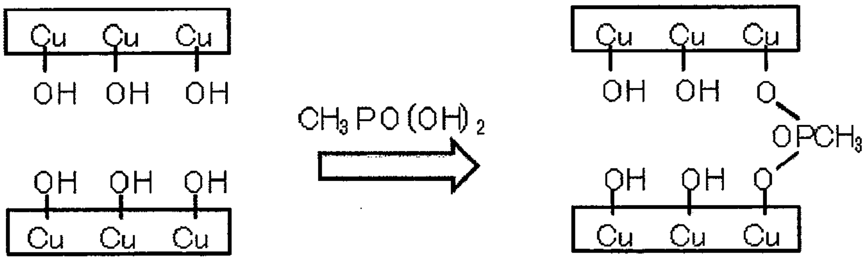


As shown in the following, firstly the first activated region 15a may react with the compound having a phosphate group, and then the second electrically conductive region 25 may react with the compound having a phosphate group.

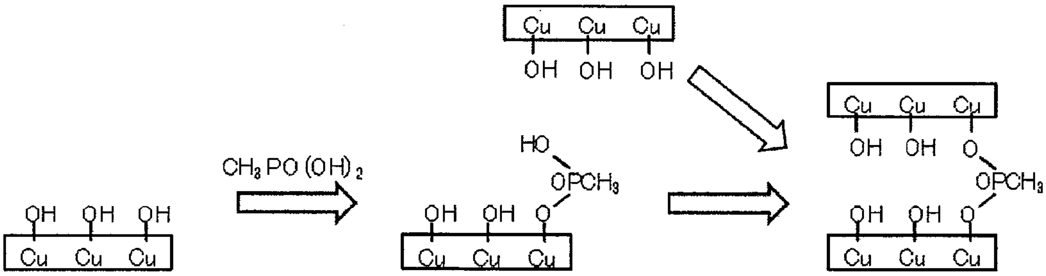


· Third example using organic material (iii) (Seventh example)

In the example, differences from the first example using the organic material (iii) described above will be mainly explained, and unless otherwise specified, the explanations described in the first example may be applied.

As the organic material, a substituted or unsubstituted hydrocarbon compound having an acid anhydride group at two terminal parts is used. The compound may have two or more terminal parts, and may have an acid anhydride group at any two or more terminal parts.

The organic material is supplied between the first silicon substrate 10 and the second silicon substrate 20, such that the acid anhydride group of the organic material reacts with the hydroxyl group in the first and second activated regions 15a and 25a. Thereby, the reaction product derived from the organic material chemically bonds to the metal atoms in the first and second activated regions 15a and 25a, so that the first and second activated regions 15a and 25a are bonded with the reaction product derived from the organic material. Further, a reaction of the acid anhydride group of the organic material with the silanol group of the first and second bonding parts may be caused. Thereby, the first reaction product derived from the organic material is chemically bound to the Si atoms of the first bonding part and the Si atoms of the second bonding part, so that the first bonding part and the second bonding part are bonded by the reaction product derived from the organic material. According to the reaction, no by-products are generated, so that the problem of formation of voids derived from by-products can be fundamentally eliminated.

As an example, a reaction with use of an alkyl compound having an anhydride group at two terminal parts is shown in the following. Incidentally, in the following, Cu is described as an example of the first and second electrically conductive regions 15 and 25. Also, in the following, although the reactions only in the first and second activated regions 15a and 25a are described, the reactions may be caused in the first and second bonding parts in the same manner as in the first and second activated regions 15a and 25a.

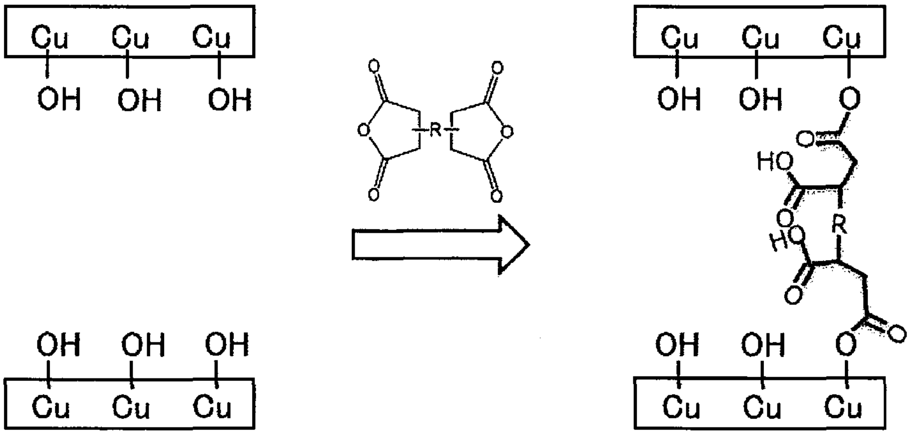

R represents an alkyl group, which is shown, for example, by $-(CH_2)_{n36}-$. Incidentally, n36 is an integer of 1 to 18. First, the first activated region 15a may react with the alkyl compound having an acid anhydride group, and then the second electrically conductive region 25 may react with the compound having an acid anhydride group. In the same manner also in the following, after the reaction with the first activated region 15a, the reaction with the second electrically conductive region 25 may be caused.

(Eighth example)

In the fifth to seventh examples, the organic material causes a chemical reaction with the first and second electrically conductive regions 15 and 25 to connect the first and second electrically conductive regions 15 and 25. The eighth example is different in that the part A is present in at least a part of the surface of the first and second electrically conductive regions 15 and 25, and no chemical reaction is caused between the first and second electrically conductive regions 15 and 25 and the part A. In other words, the first and second electrically conductive regions 15 and 25 are not connected through the part A. Apart from that, the structure is the same as in the example 5, and the part A has the same structure as in the example 2.

In the above, the first to third examples with use of a substituted or unsubstituted hydrocarbon compound having a hydrolyzable silyl group, an isocyanate group, or an acid anhydride group at two terminal parts as the organic material have been described; however, instead of/in addition to a hydrolyzable silyl group, an isocyanate group, or an acid anhydride group, a substituted or unsubstituted hydrocarbon compound having a hydroxyl group, an epoxy group and/or an amino group may be used. Any of the hydroxyl group, hydrolyzable silyl group, isocyanate group, epoxy group, amino group and acid anhydride group can function as a reactive group for silanol groups. These reactive groups on at least two terminal parts may be the same or different.

· Example using organic material (iv) (Ninth example)

In the example, differences from the first example using the organic material (iii) described above will be mainly explained, and unless otherwise specified, the explanations described in the first example may be applied.

As the organic material, silsesquioxane is used. Silsesquioxane means a silicon-containing polymer having a main chain composed of siloxane bonds (polysiloxane) with a T unit as fundamental structural unit. Silsesquioxane can be represented by a composition formula $(R'SiO_{1.5})_n$ (R' may be any organic group and n is 6 or more), and may have a random structure, a ladder structure, a cage structure (complete cage structure and incomplete cage structure) or the like. Examples of the hydrocarbon group R' include an acyclic or cyclic aliphatic hydrocarbon group such as methyl, ethyl, propyl (n-propyl, i-propyl), butyl (n-butyl, i-butyl, t-butyl, sec-butyl), pentyl (n-pentyl, i-pentyl, neopentyl, cyclopentyl, etc.), hexyl (n-hexyl, i-hexyl, cyclohexyl, etc.), heptyl (n-heptyl, i-heptyl, etc.), octyl (n-octyl, i-octyl, t-octyl, etc.), nonyl (n-nonyl, i-nonyl, etc.), decyl (n-decyl, i-decyl, etc.), undecyl (n-undecyl, i-undecyl, etc.), and dodecyl (n-dodecyl, i-dodecyl, etc.), an acyclic and cyclic alkenyl group such as vinyl, propenyl, butenyl, pentenyl, hexenyl, cyclohexenyl, cyclohexenylethyl, norbornenylethyl, heptenyl, octenyl, nonenyl, decenyl, undecenyl, dodecenyl, and styrenyl, an aralkyl group such as benzyl, phenethyl, 2-methylbenzyl, 3-methylbenzyl, and 4-methylbenzyl, an aralkenyl group such as PhCH=CH- group, an aryl group such as phenyl group, tolyl group, or xylyl group, and a substituted aryl group such as 4-aminophenyl group, 4-hydroxyphenyl group, 4-methoxyphenyl group, and 4-vinylphenyl group.

The organic material is supplied between the first silicon substrate 10 and the second silicon substrate 20, such that the siloxane bond part of the organic material reacts with the hydroxyl group in the first and second activated regions 15a and 25a. Thereby, the first reaction product derived from the organic material chemically bonds to the metal atoms in

the first and second electrically conductive regions 15 and 25, so that the first and second electrically conductive regions 15 and 25 are bonded to the first reaction product derived from the organic material. Further, the organic material is supplied between the first bonding part and the second bonding part to cause a reaction between the siloxane bond part of the organic material and the silanol group of the first and second bonding parts (cleavage addition of siloxane bond). Thereby, the reaction product derived from the first organic material is chemically bound to the Si atoms of the first bonding part and the Si atoms of the second bonding part, so that the first bonding part and the second bonding part are bonded by the reaction product derived from the organic material. According to the reaction, no by-products are generated, so that the problem of formation of voids derived from by-products can be fundamentally eliminated.

An exemplary reaction with use of $T_8$ silsesquioxane ($(R'SiO_{1.5})_8$ having a complete cage structure is shown in the following. Incidentally, in the following, Cu is described as an example of the first and second electrically conductive regions 15 and 25. Also, in the following, although the reactions only in the first and second activated regions 15a and 25a are described, the reactions may be caused in the first and second bonding parts in the same manner as in the first and second activated regions 15a and 25a.

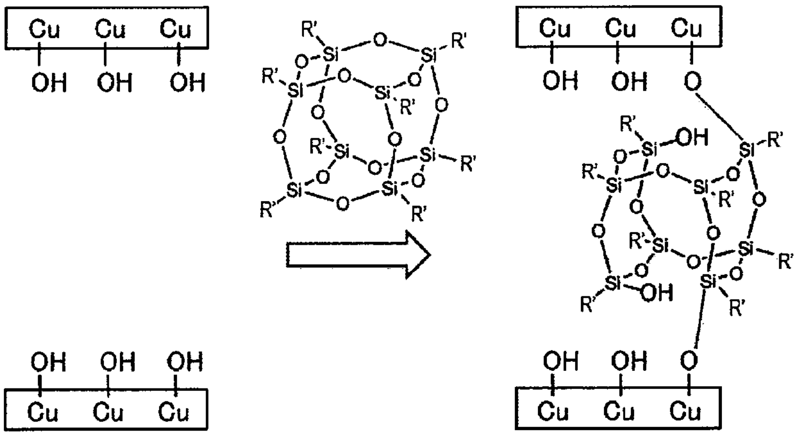

In order to obtain higher bonding strength, it is preferable that the organic material be a cage-type silsesquioxane having a definite molecular structure, though not limited thereto.

(Tenth example)

In the ninth example, the organic material causes a chemical reaction with the first and second electrically conductive regions 15 and 25 to connect the first and second electrically conductive regions 15 and 25. The tenth example is different in that the part A is present in at least a part of the surface of the first and second electrically conductive regions 15 and 25, and no chemical reaction is caused between the first and second electrically conductive regions 15 and 25 and the part A. In other words, the first and second electrically conductive regions 15 and 25 are not connected through the part A. Apart from that, the structure is the same as in the example 9, and the part A has the same structure as in the example 2.

The example with use of silsesquioxane as the organic material has been described in the above; however, a derivative of silsesquioxane may be also used. The derivative of silsesquioxane may be a compound derived from silsesquioxane, and may have any substituent, modifying group, functional group, or the like.

(Reaction condition of organic material)

Although the reaction conditions may vary depending on the organic material used, the predetermined temperature may be, for example, 200°C or less, particularly 120°C or less, more particularly 80°C or less, and conveniently normal temperature (typically 10°C or more and 40°C or less). According to the present embodiment, bonding can be performed at such relatively low temperature, so that highly accurate bonding can be achieved with a reduced displacement caused by thermal expansion of the first and second silicon substrates 10 and 20. The pressure (absolute pressure, also the same for other pressure values in the present specification) is, for example, $10^{-8}$ Pa or more, particularly $10^{-5}$ Pa or more, more particularly $10^{-1}$ Pa or more, and still more particularly $10^{2}$ Pa or more, and conveniently normal pressure (typically about $1.01 \times 10^{5}$ Pa). In the case where a reduced pressure is applied, the pressure may be, for example, $10^{5}$ Pa or less, particularly $10^{4}$ Pa or less, more particularly $10^{3}$ Pa or less.

By the production method, a layered product 40 having a first silicon substrate 10, a second silicon substrate 20, and an adhesive layer 30 between the first silicon substrate 10 and the second silicon substrate 20, is formed. In other words, the layered product 40 has:

a first silicon substrate 10 having a first electrically conductive region 15 on at least a part of the surface;
a second silicon substrate 20 on the side of a surface having the first electrically conductive region 15; and
an adhesive layer 30 that is located between the first silicon substrate 10 and the second silicon substrate 20 and that bonds the surface having the first electrically conductive region 15 of the first silicon substrate 10 to the second silicon substrate 20,
wherein there is conductivity between the first silicon substrate 10 and the second silicon substrate 20.

The adhesive layer 30 may include two or more layers.
Preferably, electric conductivity measured at the adhesive layer 30 disposed on the first silicon substrate 10 is in the range of $1.0\times10^{-2}$ to $5.0\times10^{2}$ pA, more preferably in the range of $1.0\times10^{-1}$ to $1.9\times10^{2}$ pA. The electric conductivity is a value measured by using SSRM.
Preferably, the resistivity is in the range of $1.5\times10^{-8}$ to $2.0\times10^{5}$ $\Omega\cdot$m, more preferably in the range of $1.6\times10^{-8}$ to $1.6\times10^{4}$ $\Omega\cdot$m.
The resistivity is a value measured by the following method.
First, two sheets of the first silicon substrate 10 are prepared. The electric conductivity (average current value) of the first sheet of the first silicon substrate 10 is measured, and the resistance value R (b) [$\Omega$] of the first silicon substrate 10 is determined based on: Voltage V [V] = Current I [pA] $\times$ Resistance R [$\Omega$]. The second sheet of the first silicon substrate 10 is surface-treated on an as needed basis, and then the organic material as raw material of the adhesive layer 30 is film deposited on the surface, so that a sample having film deposition on the first silicon substrate 10 is formed. The electric conductivity of the sample is measured to determine the resistance value R (all [$\Omega$]). From R (all) = Resistance value of film deposited part R (a) + R (b), the value of R (a) is obtained. Then, based on R (a) [$\Omega$] = Resistivity of sample [$\Omega\cdot$m] $\times$ Film thickness of sample [m]/Effective area of probe [$m^2$], the resistivity of the sample is determined. The electric conductivity is measured by using SSRM.

<Second embodiment>

Figure 2 is a schematic cross-sectional diagram showing a part of a layered product 40A in a second embodiment. In the first embodiment, the adhesive layer 30 is present between the first electrically conductive region 15 and the second electrically conductive region 25. The second embodiment is different in that an adhesive layer 30A is present between the first electrically conductive region 15 and the second electrically conductive region 25, the adhesive layer 30A has a first adhesive part 31A located on the first electrically conductive region 15 and a second adhesive part 32A located on the second electrically conductive region 25, and at least a part of the second electrically conductive region 25 has the second activated region 25a. The following description focuses on the different points, and unless otherwise specified, regarding other points, the structure is the same as described above.

(Adhesive layer 30A)

As shown in Figure 2, the adhesive layer 30A has a first adhesive part 31A and a second adhesive part 32A that is provided on the second silicon substrate 20 and chemically bonded to the first adhesive part 31A. The first adhesive part 31A and the second adhesive part 32A are bonded through a reaction. In the chemical bonding reaction, heating and/or increasing or decreasing pressure are performed on an as needed basis. The conditions for heating and increasing or decreasing pressure are the same as in the first embodiment. The physical properties of the adhesive layer 30A are similar to those of the adhesive layer 30 in the first embodiment.
The thickness of the adhesive layer 30A may be extremely thin. The thickness of the adhesive layer 30A is, for example, 10 nm or less, and may be, in particular, 8 nm or less, 5 nm or less, 3 nm or less, or 1.5 nm or less. The lower limit of the thickness of the adhesive layer 30A may be, for example, 1 nm or more, though not limited thereto. The thickness may be measured in the same manner as in the first embodiment.
The first adhesive part 31A includes a first reaction product derived from a first organic material reactable with the first activated region 15a. In other words, the structure of the first reaction product depends on the construction of the first organic material. The first adhesive part 31A may be obtained by applying the first organic material to the first activated region 15a and, on an as needed basis, the first bonding part, and then drying the applied material. The drying may be performed in the same manner as in the first embodiment.
The second adhesive part 32A includes a second reaction product derived from a second organic material reactable with the second activated region 25a. In other words, the structure of the second reaction product depends on the construction of the second organic material. The second adhesive part 32A may be obtained by applying the second organic material to the second activated region 25a and, on an as needed basis, the second bonding part, and then drying the applied material. The drying may be performed in the same manner as in the first embodiment.
In other words, the second silicon substrate 20 has the second electrically conductive region 25 on at least a part

of the surface, and
the adhesive layer 30A is provided on the second activated region 25a provided by activating at least a part of the surface of the second silicon substrate 20 on the side of the second electrically conductive region 25, and includes the second reaction product derived from the second organic material.

The first adhesive part 31A and the second adhesive part 32A described for convenience may have no boundary surface or may be mixed. In the case where a boundary surface is formed, the boundary surface may not be a uniform surface, or may be uneven.

(First and second organic materials)

The first organic material has a functional group reactable with the first electrically conductive region 15 or the first bonding part at one terminal part, and a functional group reactable with the second organic material at the other terminal part. The second organic material has a functional group reactable with the second electrically conductive region 25 or the second bonding part at one terminal part, and a functional group reactable with the first organic material at the other terminal part. Thereby, the first silicon substrate 10 is bonded to the second silicon substrate 20. It may be that only a part of the functional group is reactable. Although the case where one organic material has two functional groups is described above, the organic material may have three or more functional groups.

The first organic material and the second organic material each may be used as a composition. The composition has the same structure as in the first embodiment.

The specific aspects of the methods for supplying and bonding the first and second organic materials (or a composition containing the first and second organic materials) may be appropriately selected depending on the organic material for use. Schematically, after supplying the first and second organic materials, in a state with the first and second organic materials lying between the first silicon substrate 10 and the second silicon substrate 20, the first silicon substrate 10 and the second silicon substrate 20 are maintained under specified reaction conditions (at specified temperature, in particular), such that the reaction proceeds.

More specifically, for example, the first organic material (which may be a composition) is applied (for example, by applying, spraying, printing, etc.) to the surface of the first silicon substrate 10 on the side having the first electrically conductive region 15 (the surface having the first activated region 15a in at least a part thereof). In the same way, the second organic material (which may be a composition) is applied (for example, by applying, spraying, printing, etc.) to the surface of the first silicon substrate 20 on the side having the second electrically conductive region 25 (the surface having the second activated region 25a in at least a part thereof). Then, washing and/or drying may be performed on an as needed basis. In the washing and drying, the same described above may be applied. In the case of using an organic material containing fluorine, pre-washing with use of a fluorine-based solvent may be performed.

Then, the first silicon substrate 10 and the second silicon substrate 20 are aligned such that the first electrically conductive region 15 faces to the second electrically conductive region 25. Thereby, the first silicon substrate 10 comes into close contact with the second silicon substrate 20 with the first organic material lying between the first electrically conductive region 15 and the second electrically conductive region 25. The first silicon substrate 10 and the second silicon substrate 20 that are in close contact are maintained under specified conditions (at specified temperature, in particular) such that the reaction proceeds during this period. Then, annealing may be performed on an as needed basis.

The description of the first organic material in the first embodiment may be applied to the physical properties of the first and second organic materials.

The first and second organic materials may include at least one selected from the group consisting of the following (v) to (vi). The organic material for use may include one compound or two or more compounds in combination. In the following description, the first activated region 15a is paired with the second activated region 25a, and the first bonding part is paired with the second bonding part, though the combination is not limited thereto. For example, the reaction product formed from the first and second organic materials may connect the first activated region 15a to the second bonding part, or may connect the first bonding part to the second activated region 25a.

(v) a combination of a hydrolyzable hydrosilane or a substituted or unsubstituted hydrocarbon compound having a hydrolyzable silyl group at one terminal part and a hydrosilyl group at the other terminal part, and a substituted or unsubstituted hydrocarbon compound having a hydrolyzable silyl group at one terminal part and an alkenyl group at the other terminal part; and
(vi) a substituted or unsubstituted hydrocarbon compound having a hydrolyzable silyl group at one terminal part and an alkyl group at the other terminal part.

Specific description is as follows.

· Example of using organic material (v) (Eleventh example)

In the example, differences from the first example using the organic material (iii) described above will be mainly explained, and unless otherwise specified, the explanations described in the first example may be applied.

As the organic material, the first organic material and the second organic material are used in combination.

The first organic material can be a hydrolyzable hydrosilane or a substituted or unsubstituted hydrocarbon compound having a hydrolyzable silyl group at one terminal part and a hydrosilyl group at the other terminal part, and may be optionally a mixture thereof. The hydrolyzable hydrosilane may be one having H and one or more hydrolyzable groups on one Si. A substituted or unsubstituted hydrocarbon compound having a hydrolyzable silyl group at one terminal part and a hydrosilyl group at the other terminal part may have two or more terminal parts, and may have a hydrolyzable silyl group at any one or more terminal parts and a hydrosilyl group at any one or more terminal parts. A substituted or unsubstituted hydrocarbon compound having a hydrolyzable silyl group at one terminal part and a hydrosilyl group at the other terminal part may be the same as the substituted or unsubstituted hydrocarbon compound having hydrolyzable silyl groups at two terminal parts described in detail in the (iii), except for having a hydrosilyl group at the other terminal part.

The second organic material is a substituted or unsubstituted hydrocarbon compound having a hydrolyzable silyl group at one terminal part and an alkenyl group at the other terminal part. The compounds may have two or more terminal parts, and may have a hydrolyzable silyl group at any one or more terminal parts, and an alkenyl group at any one or more terminal parts. The substituted or unsubstituted hydrocarbon compound having a hydrolyzable silyl group at one terminal part and an alkenyl group at the other terminal part may be the same as the substituted or unsubstituted hydrocarbon compound having a hydrolyzable silyl group at two terminal parts described in detail in the (iii), except for having an alkenyl group at the other terminal part.

First, the first organic material is supplied to the first silicon substrate 10 to cause a reaction with the hydroxyl group of the first activated region 15a. Further, the first organic material is supplied to the second silicon substrate 20 to cause a reaction with the hydroxyl group of the second activated region 25a. The hydrolyzable silyl group of the first organic material may react with the silanol groups of the first bonding part (for example, in the case where the hydrolyzable group is an alkoxy group, a siloxane bonding is formed by dealcoholization), and the hydrolyzable silyl group of the second organic material may react with the silanol group of the second bonding part (for example, in the case where the hydrolyzable group is an alkoxy group, a siloxane bonding is formed by dealcoholization).

The first electrically conductive region 15 and the second electrically conductive region 25 are then disposed facing each other with an intermediate derived from the first organic material and an intermediate derived from the second organic material being located therebetween to cause a reaction of the intermediates (hydrosilylation). Thereby, the reaction product derived from the first organic material and the second organic material causes a reaction with the metal atoms in the first and second electrically conductive regions 15 and 25, so that the reaction product derived from the first and second organic materials is bonded to the first and second electrically conductive regions 15 and 25. Further, the first organic material and the second organic material chemically bond to the Si atoms of the first bonding part and the Si atoms of the second bonding part, so that the first bonding part and the second bonding part may be bonded with the reaction product derived from the first organic material and the second organic material. Although an alcohol is produced as a by-product in the reaction, the number of carbon atoms thereof can be small as described above, so that the by-product can be effectively removed before disposing the first silicon substrate 10 and the second silicon substrate 20 facing each other. Therefore, the formation of voids derived from by-products can be reduced.

For example, as the first organic material, $R^k{}_3Si\text{-}(CH_2)_{n37}\text{-}CH{=}CH_2$ may be used, and as the second organic material, $SiHR^k{}_3$ may be used. $R^k$ each independently mean a group to be subjected to hydrolysis reaction, which is specifically equivalent to the above. Incidentally, n37 is an integer of 0 to 18, for example, 0.

Specifically, in the case of using vinyltrimethoxysilane as the first organic material and using trimethoxy hydrosilane as the second organic material, the reaction is shown in the following. In the following, as an example of the first and second electrically conductive regions 15 and 25, Cu is described. Also, in the following, although the reactions only in the first and second activated regions 15a and 25a are described, the reactions may be caused in the first and second bonding parts in the same manner as in the first and second activated regions 15a and 25a.

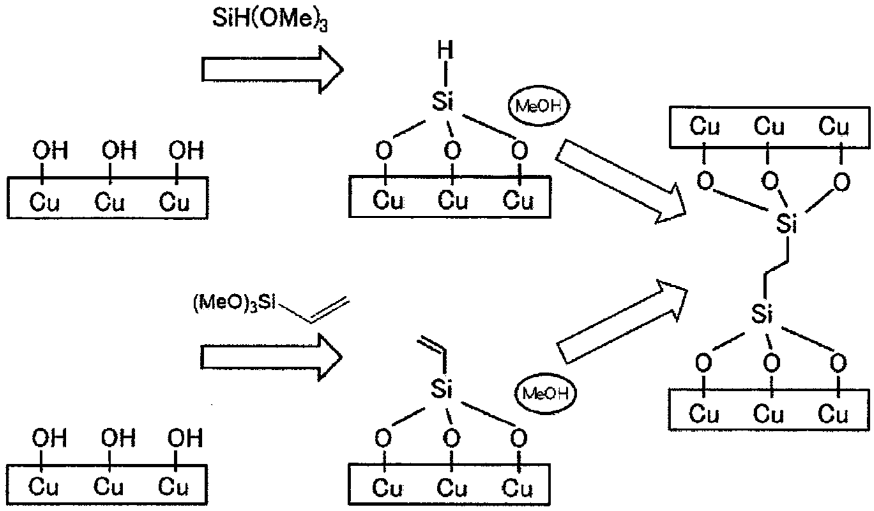


(Twelfth example)

In the eleventh example, the first organic material causes a reaction with the first electrically conductive region 15, and the second organic material causes a reaction with the second electrically conductive region 25. Due to the reactions of the first organic material and the second organic material, the first electrically conductive region 15 and second electrically conductive regions 25 are connected. The twelfth example is different in that the part A is present in at least a part of the surface of the first and second electrically conductive regions 15 and 25, and no chemical reaction is caused between the first and second electrically conductive regions 15 and 25 and the part A. In other words, the first and second electrically conductive regions 15 and 25 are not connected through the part A. Apart from that, the structure is the same as in the example 11.

Specifically, in the case of using vinyltrimethoxysilane as the first organic material and trimethoxy hydrosilane as the second organic material, the first organic material reacts with Si atoms of the first bonding part, and the second organic compound is bonded to the Si atoms of the second bonding part. Then, the first bonding part and the second bonding part may be bonded with the reaction product derived from the first organic material and the second organic material.

The part A is present between the metal atoms of the first electrically conductive region 15 and the metal atoms of the second electrically conductive region 25. The part A is located in at least a part of the surface between the first and second electrically conductive regions 15 and 25. The part A is unreacted with the metal atoms in the first electrically conductive region 15 and the second electrically conductive region 25. The whole surface of the first electrically conductive region 15 and the second electrically conductive region 25 may have the part A, or a part of the surface may have the part A and another part may have no part A. The part A has the same structure as described above.

· Example of using organic material (vi) (Thirteenth example)

In this example, the following description focuses on the different points from the first example in which the organic material (iii) is used, and unless otherwise specified, the same description as in the first example may apply below.

As the first and second organic materials, a substituted or unsubstituted hydrocarbon compound having a hydrolyzable silyl group at one terminal part and an alkyl group at the other terminal part, respectively, is used. The compound may have two or more terminal parts, and may have a hydrolyzable silyl group at any one or more terminal parts and an alkyl group at any one or more terminal parts. A substituted or unsubstituted hydrocarbon compound having a hydrolyzable silyl group at one terminal part and an alkyl group at the other terminal part may be the same as the substituted or unsubstituted hydrocarbon compound having hydrolyzable silyl groups at two terminal parts described in detail in the (iii), except for having an alkyl group at the other terminal part. The second organic material may have the same structure as that of the first organic material, or may have a different structure.

The first organic material is supplied to the first silicon substrate 10 to cause a reaction with the hydroxyl group in the first activated region 15a. Further, the first organic material is supplied to the second silicon substrate 20 to cause a reaction with the hydroxyl group in the second activated region 25a. The first organic material is supplied to the first bonding part so that the hydrolyzable silyl group of the first organic material may react with the silanol groups of the first bonding part (for example, in the case where the hydrolyzable group is an alkoxy group, a siloxane bonding is formed by dealcoholization), and the second organic material is supplied to the second bonding part so that the hydrolyzable silyl group of the second organic material may react with the silanol group of the second bonding part (for example, in the case where the

hydrolyzable group is an alkoxy group, a siloxane bonding is formed by dealcoholization).

The first electrically conductive region 15 and the second electrically conductive region 25 are then disposed facing each other, with an intermediate derived from the first organic material and an intermediate derived from the second organic material being located therebetween to cause a reaction between the intermediates (radical reaction). On this occasion, an intermediate derived from the first organic material and an intermediate derived from the second organic material, which are present between the first bonding part and the second bonding part, are also subjected to a reaction in the same manner. The reaction between the intermediates (radical reaction) may be performed by UV irradiation, ion beams, weak plasma, or the like. Thereby, the reaction product derived from the first organic material and the second organic material reacts with the metal atoms of the first and second electrically conductive regions 15 and 25 and/or the Si atoms of the first and second bonding parts, so that the reaction product derived from the first and second organic materials is bonded to the first and second electrically conductive regions 15 and 25 and/or the first and second bonding parts. Although an alcohol is produced as a by-product in such a reaction, the number of carbon atoms thereof can be small as described above. As a result, the by-product can be effectively removed before disposing the first silicon substrate 10 and the second silicon substrate 20 facing each other, so that the formation of voids derived from by-products can be reduced.

For example, as the first organic material and the second organic material, $R^k{}_3Si(CH_2)_{n38}H$ may be used. $R^k$ each independently mean a group that may be subjected to a hydrolysis reaction, and specifically is the same as the above. Incidentally, n38 is an integer of 2 to 18, and, for example, 0.

Specifically, in the case of using ethyltrimethoxysilane as the first and second organic materials, the reaction is shown in the following. In the following, as an example of the first and second electrically conductive regions 15 and 25, Cu is described. Also, in the following, although the reactions only in the first and second activated regions 15a and 25a are described, the reactions may be caused in the first and second bonding parts in the same manner as in the first and second activated regions 15a and 25a.

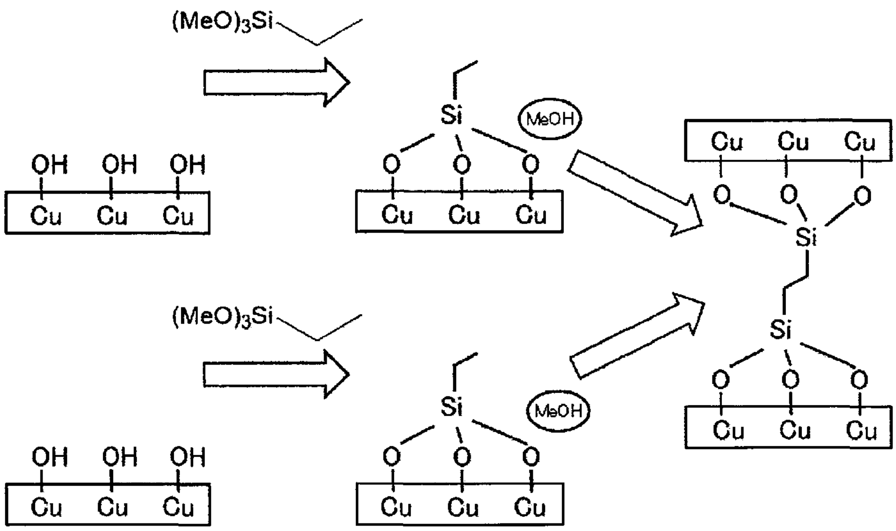

By the production method, the layered product 40A having the first silicon substrate 10, the second silicon substrate 20 and the adhesive layer 30A between the first silicon substrate 10 and the second silicon substrate 20 is formed, and the adhesive layer 30A has a first adhesive part 31A and a second adhesive part 32A.

By the production method described above, a layered product 40 having a first silicon substrate 10, a second silicon substrate 20, and an adhesive layer 30A between the first silicon substrate 10 and the second silicon substrate 20 is formed. In other words, a layered product 40A has:

a first silicon substrate 10 having a first electrically conductive region 15 on at least a part of the surface;
a second silicon substrate 20 on a side having the first electrically conductive region 15; and
an adhesive layer 30A that is located between the first silicon substrate 10 and the second silicon substrate 20 and that bonds the surface having the first electrically conductive region 15 of the first silicon substrate 10 to the second electrically conductive region 25 of the second silicon substrate 20;
wherein
the adhesive layer 30A has a reaction product between the first adhesive part 31A located on the first electrically conductive region 15 and the second adhesive part 32A located on the first electrically conductive region 15;
the layered product has electric conductivity between the first silicon substrate 10 and the second silicon substrate 20.

The physical properties of the layered product 40A is the same as the physical properties of the layered product 40 in the first embodiment.

(Fourteenth example)

In the thirteenth example, the first organic material reacts with the first electrically conductive region 15, and the second organic material reacts with the second electrically conductive region 25. Accordingly, through the chemical reaction of the first and second electrically conductive regions 15 and 25, the first and second electrically conductive regions are connected. The fourteenth example is different in that the part A is present in at least a part of the surface of the first and second electrically conductive regions 15 and 25, and no chemical reaction occurs between the first and second electrically conductive regions 15 and 25 and the part A. In other words, the first and second electrically conductive regions 15 and 25 are not chemically connected through the part A. Apart from that, the structure is the same as in the example 13, and the part A has the same structure as in the example 2.

(Modified example)

Figure 3 is a schematic cross-sectional diagram showing a part of a layered product 40B in a modified example. In the modified example in contrast to the second embodiment, a first adhesive part 31B is present on the first electrically conductive region 15, a second adhesive part 32B is present on the second electrically conductive region 25, and a third adhesive part 33B is present between the first adhesive part 31B and the second adhesive part 32B, respectively, so that the first adhesive part 31B and the third adhesive part 33B are bonded and the second adhesive part 32B and the third adhesive part 33B are bonded. In other words, the adhesive layer 30B includes three layers: the first adhesive part 31B, the third adhesive part 33B, and the second adhesive part 32B. The different structure is described as follows. Other structure is the same as in the first embodiment, so that the description is omitted.

(Adhesive layer 30B)

The adhesive layer 30B has a first adhesive part 31B, a third adhesive part 33B and a second adhesive part 32B in this order. The first adhesive part 31B is provided on the first silicon substrate 10, the second adhesive part 32B is provided on the second silicon substrate 20, and the third adhesive part 33 is reactable with the first adhesive part 31B at one terminal part, and reactable with the second adhesive part 32B at the other terminal part. In other words, the third adhesive part 33 is reactable as connection part that connects the first adhesive part 31B to the second adhesive part 32B. The reaction is performed under heated and/or increased or decreased pressure on an as needed basis. The conditions for heating and increasing or decreasing pressure are the same as in the first embodiment.

The thickness of the adhesive layer 30B may be extremely thin. The thickness of the adhesive layer 30B is, for example, 10 nm or less, and may be, in particular, 8 nm or less, 5 nm or less, 3 nm or less, or 1.5 nm or less. The lower limit of the thickness of the adhesive layer 30B may be, for example, 1 nm or more, though not limited thereto. The thickness may be measured in the same manner as in the first embodiment.

The first adhesive part 31B includes a first reaction product derived from a first organic material reactable with the first activated region 15a. In other words, the structure of the first reaction product depends on the construction of the first organic material. The first adhesive part 31B may be obtained by applying the first organic material to the first activated region 15a and, on an as needed basis, the first bonding part, and then drying the applied material. The drying may be performed in the same manner as in the first embodiment.

The second adhesive part 32B includes a second reaction product derived from a second organic material reactable with the second activated region 25a. In other words, the structure of the second reaction product depends on the construction of the second organic material. The second adhesive part 32B may be obtained by applying the second organic material to the second activated region 52a and, on an as needed basis, the second bonding part, and then drying the applied material. The drying may be performed in the same manner as in the first embodiment.

The third adhesive part 33B includes a reaction product derived from a third organic material reactable with the first organic material and the second organic material. The third adhesive part 33B may be obtained by applying the third organic material to the first reaction product and, on an as needed basis, the first bonding part, and then drying the applied material. The drying may be performed in the same manner as in the first embodiment.

The first adhesive part 31A, the second adhesive part 32A, and the third adhesive part 33B described for convenience may have no boundary surface, or may be mixed. In the case where a boundary surface is formed, the boundary surface may not be a uniform surface, or may be uneven.

(First to third organic materials)

The first organic material has a functional group reactable with the first electrically conductive region 15B or the first bonding part at one terminal part, and a functional group reactable with the third organic material at the other terminal part. The second organic material has a functional group reactable with the second electrically conductive region 25B or the second bonding part at one terminal part, and a functional group reactable with the third organic material at the other terminal part. The third organic material has a functional group reactable with the first organic material at one terminal part, and a functional group reactable with the second organic material at the other terminal part. Thereby, the first silicon substrate 10 is bonded to the second silicon substrate 20. Incidentally, only a part of these functional groups may cause a reaction. Although the case where one organic material has two functional groups is described above, the organic material may have three or more functional groups.

The first to third organic materials each may be used as a composition. The composition has the same structure as in the first embodiment.

The specific aspects of the methods for supplying and bonding the first to third organic materials (or a composition containing the first to third organic materials) may be appropriately selected depending on the organic material for use. Schematically, after supplying the first to third organic materials, in a state with the organic materials lying between the first silicon substrate 10 and the second silicon substrate 20, the first silicon substrate 10 and the second silicon substrate 20 are maintained under specified reaction conditions (at specified temperature, in particular), such that the reaction proceeds.

More specifically, for example, the first organic material (which may be a composition) is applied (for example, by applying, spraying, printing, etc.) to the surface of the first silicon substrate 10 on the side having the first electrically conductive region 15 (the surface having the first activated region 15a in at least a part thereof). In the same way, the second organic material (which may be a composition) is applied to the surface of the second silicon substrate on the side having the second electrically conductive region 25 (the surface having the second activated region 25a in at least a part thereof). Then, washing and/or drying may be performed on an as needed basis. In the washing and drying, the same described above may be applied. In the case of using an organic material containing fluorine, pre-washing with use of a fluorine-based solvent may be performed.

Then, the third organic material (which may be a composition) is applied (for example, by applying, spraying, printing, etc.) on the region derived from the first organic material. Then, washing and/or drying may be performed on an as needed basis. In the washing and drying, the same described above may be applied. In the case of using an organic material containing fluorine, pre-washing with use of a fluorine-based solvent may be performed.

Further after that, a region derived from the second organic material is provided on the region derived from the third organic material. Specifically, the first silicon substrate 10 and the second silicon substrate 20 are aligned such that the first electrically conductive region 15 are faced to the second electrically conductive region 25. Thereby, the first silicon substrate 10 comes into close contact with the second silicon substrate 20 with the first to third organic materials lying between the first electrically conductive region 15 and the second electrically conductive region 25. The first silicon substrate 10 and the second silicon substrate 20 that are in close contact are maintained under specified conditions (at specified temperature, in particular) such that the reaction proceeds during this period. Then, annealing may be performed on an as needed basis.

The description of the first organic material in the first embodiment may be applied to the physical properties of the first to third organic materials.

The description of the first organic material in the first embodiment may be applied to the physical properties of the first to third organic materials.

Each of the organic materials is shown as follows. The following description focuses on the different points from the first example in which the organic material (iii) is used, and unless otherwise specified, the same description as in the first example may apply below.

As the organic materials, the following materials may be used.

(vii) a substituted or unsubstituted hydrocarbon compound having a hydrolyzable silyl group at one terminal part and a reactive functional group at the other terminal part

Illustrative aspects are described in detail as follows.

· Example using organic material (vii) (Fifteenth example)

In the example, differences from the first example using the organic material (iii) described above will be mainly explained, and unless otherwise specified, the explanations described in the first example may be applied.

As the first and second organic materials, a substituted or unsubstituted hydrocarbon compound having a hydrolyzable silyl group at one terminal part and a reactive functional group at the other terminal part is used. The compound may have two or more terminal parts, and may have a hydrolyzable silyl group at any one or more terminal parts

and a reactive functional group at any one or more terminal parts. The first and second organic materials may be the same as the substituted or unsubstituted hydrocarbon compound having a hydrolyzable silyl group at two terminal parts described in detail in the (iii), except for having a reactive functional group at the other terminal part. Incidentally, except for the terminal part, the first organic material and the second organic material may have the same structure or may have a different structure.

The reactive functional group may be typically at least one selected from the group consisting of an isocyanate group, an amino group, a hydroxyl group, a thiol group (also referred to as sulfanyl group), etc., though not limited thereto.

In the present embodiment, a third organic material is further used. The third organic material has two groups bondable to a reactive functional group of the first and second organic materials. The third organic material may have two or more bindable groups, and more specifically may have the bindable groups at any two or more terminal parts. The number of carbons of the portion of the third organic material except for the bindable group is not limited, and may be, for example, 1 or more and 20 or less, particularly 5 or less. The portion except for the bindable group may be in a linear, branched or cyclic form. Typically, the third organic material may be a linear organic compound having a bindable group at both terminal parts, though not limited thereto.

The bindable group is selected depending on the reactive functional group. Examples of the combination of the reactive functional group and the group bindable thereto are shown in the following, though not limited thereto. One or more reactive functional groups may be used, and one or more bindable groups may be used as long as they can be bindable to the reactive functional groups.

[Table 1]

| Reactable functional group in organic material | Bondable group in organic binding agent |
|---|---|
| isocyanate group | amino group, hydroxyl group, thiol group |
| amino group | isocyanate group |
| hydroxyl group | isocyanate group |
| thiol group | isocyanate group |

The reactive functional group and the bondable group may be a hydroxyl group and/or a hydrogen atom, and one that is reactive or substantially non-reactive with a hydrosilyl group and/or a silanol group. In the case where all of the reactive functional groups and the bondable groups are hydroxyl groups and/or hydrogen atoms and the ones reactive with a hydrosilyl group and/or a silanol group, it is possible to consider use of two types of organic materials (iii), which is not taken into consideration in the case of using the organic material (vii).

For example, in the case of using $R^k{}_3Si-(CH_2)_{n31}-NCO$ as the first organic material and the second organic material, for example, at least one of $H_2N-(CH_2)_{n32}-NH_2$, $HS-(CH_2)_{n32}-SH$, and $HO-(CH_2)_{n32}-OH$, may be used as the third organic material. In the case of using $R^k{}_3Si-(CH_2)_{n33}-NH_2$ as the first organic material and the second organic material, $OCN-(CH_2)_{n34}-NCO$ may be used as the third organic material. Incidentally, n31 is an integer of 1 to 18, and, for example, 1. Further, n32 are each independently an integer of 1 to 18, and, for example, 2. Further, n33 is an integer of 1 to 18, and, for example, 1. Further, n34 is an integer of 1 to 18, and, for example, 2.

$R^k$ means a group that is subject to a hydrolysis reaction, preferably each independently are $-OR^j$, $-OCOR^j$, $-O-N=CR^j{}_2$, $-NR^j{}_2$, $-NHR^j$ or a halogen. $R^j$ is a substituted or unsubstituted $C_{1-4}$ alkyl group, preferably an unsubstituted $C_{1-4}$ alkyl group. The $C_{1-4}$ alkyl group is preferably an ethyl group or a methyl group, more preferably a methyl group.

Specifically, in the case of using isocyanate methyl trimethoxysilane as the first organic material and the second organic material, and ethylene diamine(1,2-diaminoethane) as the third organic material, the reaction is described as follows. In the following schematic diagram, the upper row shows the bonding part of one substrate only for convenience. The first method corresponds to the scheme indicated by the arrow pointing from the left side of the upper row to the lower row. The second method corresponds to the scheme indicated by the arrow pointing from the left side of the upper row to the center of the upper row and the arrow pointing from the center of the upper row to the lower row. The third method corresponds to the scheme indicated by the arrow pointing from the left side of the upper row to the center of the upper row, the arrow pointing from the center of the upper row to the right side of the upper row, and the arrow pointing from the right side of the upper row to the lower row (the same shall apply hereinafter). As an example of the first and second electrically conductive regions 15 and 25, Cu is described in the following. Although only the reactions in the first and second activated regions 15a and 25a are described in the following, the reactions may occur also in the first and second bonding parts 23 in the same manner as in the first and second activated regions 15a and 25a.

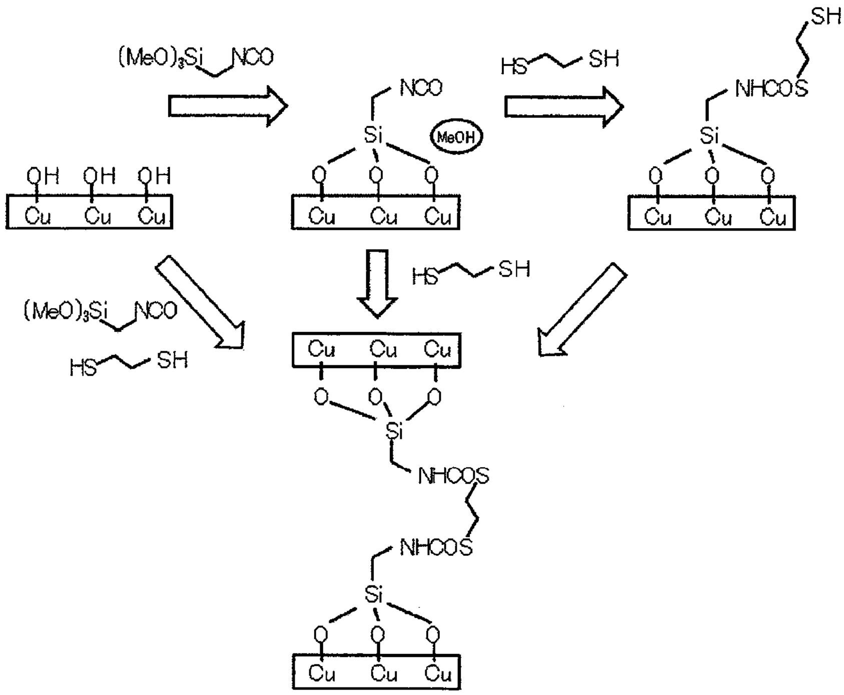

Specifically, in the case of using isocyanate methyl trimethoxysilane as the first organic material and the second organic material, and ethylene glycol (1,2-ethane diol) as the third organic material, the reaction is described as follows.

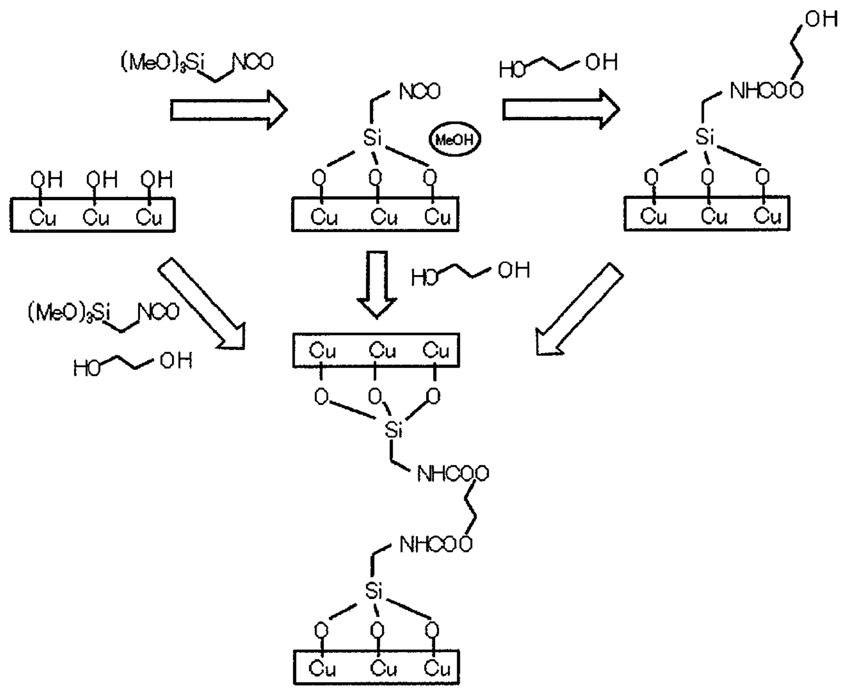

Specifically, in the case of using aminomethyl trimethoxysilane as the first and second organic materials, and ethylene diisocyanate(1,2-ethane diisocyanate) as the third organic material, the reaction is described as follows.

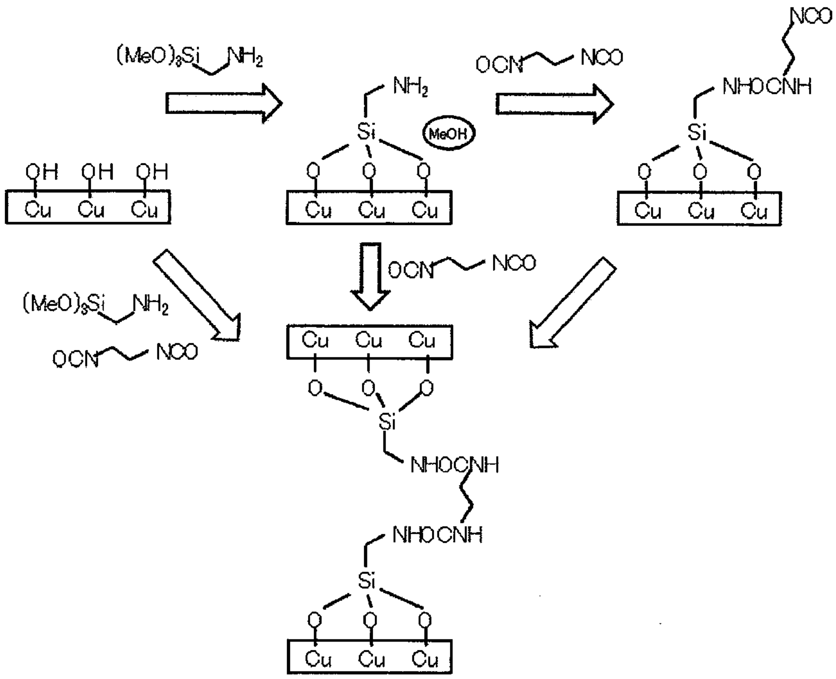

Any appropriate method (scheme) may be applied for bonding the first silicon substrate 10 and the second silicon substrate 20 using the first to third organic materials. Three methods are shown in the following, though not limited thereto.

(First method)

In a first method, the first and second organic materials and the third organic material are mixed (for example, immediately before use), and the resulting mixture is supplied between the first silicon substrate 10 and the second silicon substrate 20, so that the hydrolyzable silyl groups of the first and second organic materials react with the hydroxyl groups of the first and second activated regions 15a and 25a. Thereby, the first organic material chemically bonds to the metal atoms of the first electrically conductive region 15 and the second organic material chemically bonds to the metal atoms of the second electrically conductive region 25. Also, the reactive functional groups of the first and second organic materials and the bondable groups of the third organic material are reacted to be bonded. Thereby, the first organic material chemically bonded to the metal atoms of the first electrically conductive region 15 and the second organic material chemically bonded to the metal atoms of the second electrically conductive region 25 are bonded through the third organic material.

Also, a reaction is caused between the hydrolyzable silyl groups of the first and second organic materials and the silanol groups of the first bonding part and the second bonding part (for example, in the case where the hydrolyzable group is an alkoxy group, a siloxane bond is formed by dealcoholization). Thereby, the first organic material chemically bonds to the Si atoms of the first bonding part, and the second organic material chemically bonds to the Si atoms of the second bonding part. Further, the reactive functional groups of the first and the second organic materials chemically bond to the bondable groups of the third organic material through a reaction. Thereby, the first organic material chemically bonded to the Si atom of the first bonding part and the second organic material chemically bonded to the Si atom of the second bonding part are bonded through the third organic material.

The reaction between the hydrolyzable silyl groups of the first organic material and the first activated region 15a or the first bonding part, the reaction between the hydrolyzable silyl group of the first organic material and the second activated region 25a or the silanol groups of the second bonding part, and the reaction between the reactive functional groups of the first and second organic materials and the bondable groups of the third organic material may occur at any timing, and for example, any of the reactions may proceed in advance, or the reactions may proceed at the same time. As a result, the first silicon substrate 10 and the second silicon substrate 20 are bonded by the reaction product derived from the first to third organic materials. Although, for example, an alcohol is produced as a by-product, the number of carbon atoms thereof can be small as described above, so that the by-product can be effectively removed to the outside through a gap between the reaction products. Accordingly, the formation of voids derived from by-products can be suppressed.

(Second method)

In a second method, the first organic material is supplied to the first activated region 15a so that the hydrolyzable

silyl group of the first organic material reacts with the hydroxyl groups of the first activated region 15a (for example, in the case where the hydrolyzable group is an alkoxy group, a siloxane bonding is formed by dealcoholization), and the second organic material is supplied to the second activated region 25a so that the hydrolyzable silyl group of the second organic material reacts with the hydroxyl group of the second activated region 25a (for example, in the case where the hydrolyzable group is an alkoxy group, a siloxane bonding is formed by dealcoholization). (The first organic material to be supplied to the first activated region 15a and the second organic material to be supplied to the second activated region 25a may be the same or different.) Thereby, the first organic material chemically bonds to the metal atoms of the first electrically conductive region 15 and the second organic material chemically bonds to metal atoms of the second electrically conductive region 25, respectively.

The first electrically conductive region 15 and the second electrically conductive region 25 are then disposed facing each other with an intermediate derived from the first and second organic materials lying therebetween together with the third organic material, so as to bond the reactive functional groups of the first and second organic materials to the bondable group of the third organic material through a reaction. Thereby, the first organic material chemically bonded to the metal atoms of the first electrically conductive region 15 and the second organic material chemically bonded to the metal atoms of the second electrically conductive region 25 are bonded through the third organic material.

Also, the first organic material is supplied to the first bonding part so that the hydrolyzable silyl group of the first organic material reacts with the silanol groups of the first bonding part (for example, in the case where the hydrolyzable group is an alkoxy group, a siloxane bonding is formed by dealcoholization), and the second organic material is supplied to the second bonding part so that the hydrolyzable silyl group of the second organic material reacts with the silanol group of the second bonding part (for example, in the case where the hydrolyzable group is an alkoxy group, a siloxane bonding is formed by dealcoholization). (The first organic material to be supplied to the first bonding part and the second organic material to be supplied to the second bonding part may be the same or different.) Thereby, the first organic material chemically bonds to the Si atoms of the first bonding part and the second organic material chemically bonds to Si atoms of the second bonding part, respectively.

The first bonding part and the second bonding part are then disposed facing each other, with an intermediate derived from the first and second organic materials lying therebetween together with the third organic material, so as to bond the reactive functional groups of the first and second organic materials to the bondable group of the third organic material through a reaction. Thereby, the first organic material chemically bonded to the Si atoms of the first bonding part and the second organic material chemically bonded to the Si atoms of the second bonding part are bonded through the third organic material.

As the result, the first electrically conductive region 15 and the second electrically conductive region 25, and the first bonding part and the second bonding part, are bonded by the reaction products derived from the first to third organic materials, respectively. Although, for example, an alcohol is produced as a by-product, the number of carbon atoms thereof can be small as described above, so that the by-product can be effectively removed before disposing the first silicon substrate 10 and the second silicon substrate 20 facing each other. Accordingly, the formation of voids derived from by-products can be suppressed.

(Third method)

In a third method, the first organic material is supplied to the first activated region 15a so that the hydrolyzable silyl group of the first organic material reacts with the hydroxyl group of the first activated region 15a (for example, in the case where the hydrolyzable group is an alkoxy group, a siloxane bonding is formed by dealcoholization), and the second organic material is supplied to the second activated region 25a so that the hydrolyzable silyl group of the second organic material reacts with the hydroxyl group of the second activated region 25a (for example, in the case where the hydrolyzable group is an alkoxy group, a siloxane bonding is formed by dealcoholization). (The first organic material to be supplied to the first activated region 15a and the second organic material to be supplied to the second activated region 25a may be the same or different.) Thereby, the first organic material chemically bonds to the metal atoms of the first electrically conductive region 15 (intermediate X1), and the second organic material chemically bonds to the metal atoms of the second electrically conductive region 25 (intermediate X2). Then, the intermediate X1 is conveniently selected as one of the intermediates X1 and X2, and the third organic material is supplied to the intermediate X1, so that the reactive functional group of the first organic material is bonded to the bondable group of the third organic material through a reaction (intermediate Y). Then the intermediate Y thus obtained and the intermediate X2 obtained in the above are disposed facing each other. The reactive functional group of the intermediate X2 (second organic material) and the bondable group of the intermediate Y (first organic material + third organic material) are bonded through a reaction. Thereby, the first organic material chemically bonded to the metal atoms of the first electrically conductive region 15 and the second organic material chemically bonded to the metal atoms of the second electrically conductive region 25 are bonded through the third organic material.

Further, the first organic material is supplied to the first bonding part so that the hydrolyzable silyl group of the first

organic material reacts with the silanol group of the first bonding part (for example, in the case where the hydrolyzable group is an alkoxy group, a siloxane bonding is formed by dealcoholization), and the second organic material is supplied to the second bonding part so that the hydrolyzable silyl group of the second organic material reacts with the silanol group of the second bonding part (for example, in the case where the hydrolyzable group is an alkoxy group, a siloxane bonding is formed by dealcoholization). (The first organic material to be supplied to the first bonding part and the second organic material to be supplied to the second bonding part may be the same or different.) Thereby, the first organic material chemically bonds to the Si atoms of the first bonding part (intermediate X1), and the second organic material chemically bonds to the Si atoms of the second bonding part (intermediate X2). Then, the intermediate X1 is conveniently selected as one of the intermediates X1 and X2, and the third organic material is supplied to the intermediate X1, so that the reactive functional group of the first organic material is bonded to the bondable group of the third organic material through a reaction (intermediate Y).

Then the intermediate Y thus obtained and the intermediate X2 obtained in the above are disposed facing each other. Reactive functional group of the intermediate X2 (the second organic material) and the bondable group of the intermediate Y (the first organic material + the third organic material) are bonded through a reaction. Thereby, the first organic material chemically bonded to the Si atoms of the first bonding part and the second organic material chemically bonded to the Si atoms of the second bonding part are bonded through the third organic material.

As a result, the first electrically conductive region 15 and the second electrically conductive region 25, and the first bonding part and the second bonding part, are bonded by the reaction product derived from the first to third organic materials. Although, for example, an alcohol is produced as a by-product, the number of carbon atoms thereof can be small as described above, so that the by-product can be effectively removed before disposing the first silicon substrate 10 and the second silicon substrate 20 facing each other. Accordingly, the formation of voids derived from by-products can be suppressed. Further, in this method, the unreacted third organic material that may remain on the intermediate Y on the first silicon substrate 10 can be effectively removed before disposing the first silicon substrate 10 and the second silicon substrate 20 facing each other. Accordingly, in a layered product to be finally obtained, the unnecessary materials (not contributing to bonding) remaining between the first silicon substrate 10 and the second silicon substrate 20 can be reduced.

(Sixteenth example)

In the fifteenth example, the first organic material reacts with the first electrically conductive region 15, and the second organic material reacts with the second electrically conductive region 25. Through the chemical reaction of the third organic material reactable with the first organic material and the second organic material, the first electrically conductive region 15 and the second electrically conductive region 25 are connected. The sixteenth example is different in that the part A is present in at least a part of the surface of the first and second electrically conductive regions 15 and 25, and no chemical reaction occurs between the first and second electrically conductive regions 15 and 25 and the part A. In other words, the first and second electrically conductive regions 15 and 25 are not chemically connected through the part A. Apart from that, the structure is the same as in the fifteenth example, and the part A has the same structure as in the second example.

The part A is present between the metal atoms of the first electrically conductive region 15 and the metal atoms of the second electrically conductive region 25. The part A is located in at least a part of the surface between the first and second electrically conductive regions 15 and 25. The part A is unreactive with the metal atoms of the first electrically conductive region 15 and the metal atoms of the second electrically conductive region 25. The whole surface of the first electrically conductive region 15 and the second electrically conductive region 25 may have the part A, or a part thereof may have the part A and the other part may have no part A. The part A has the same structure as described above.

The embodiment of the present disclosure has been described above, though the present disclosure is not limited to the embodiment and various modifications may be made.

Example

The present disclosure is more specifically described with reference to the following examples, though not limited thereto.

(Comparative Example 1)

One Cu wafer was exposed to $N_2$, RIE plasma at 250 W for 3 minutes.

(Example 1)

· Preparation of sample for measurement of electric conductivity and resistivity

One Cu wafer was exposed to $N_2$, RIE plasma, so that the surface of the wafer was activated and organic contamination was removed.

A solution of 1,6-bis(trimethoxysilyl)hexane (5 wt%, 2-methoxy-1-methylethyl acetate (PGMEA) solution) was filtered to remove particles.

The PGMEA solution was then provided on the wafer by spin-coating for film deposition. After standing still for 5 minutes, the surface of the wafer was cleaned with PGMEA to wash away organic materials not in close contact. Through subsequent heating at 100°C for 5 minutes on a hot stage to cause a reaction between the wafer and the organic material, an organic film was formed on the wafer (in other words, in Example 1, a reaction product of the organic material was located on a wafer).

The wafer thus obtained was then subjected to measurement of electric conductivity and resistivity.

1,6-Bis(trimethoxysilyl)hexane:

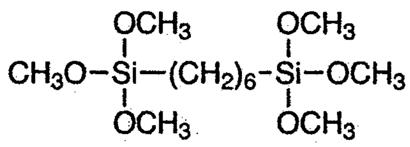

(Example 2)

The procedure was performed in the same manner as in Example 1, except that bis[3-(trimethoxysilyl)propyl] amine was used as the first organic material, instead of 1,6-bis(trimethoxysilyl)hexane in Example 1.

Bis[3-(trimethoxysilyl)propyl]amine:

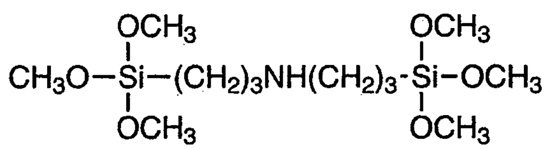

(Example 3)

The procedure was performed in the same manner as in Example 1, except that 1,6-hexylenediphosphonic acid was used as the first organic material, instead of 1,6-bis(trimethoxysilyl)hexane in Example 1.

1,6-Hexylenediphosphonic acid:

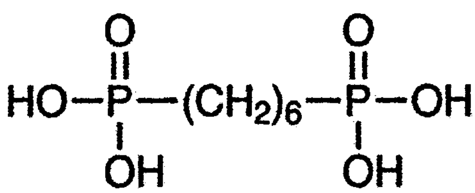

{Conditions for plasma application}

- Apparatus: AQ-500 manufactured by Mikasa Co., Ltd.
- Plasma for application: $N_2$
- Application time: 3 minutes
- Application output: 250 W

{Conditions for measurement of film thickness}

The film thickness was measured by using an ellipsometer.

- Measurement wavelength region: 400 to 1000 nm
- Incidence angle: 65°

Before film deposition (after pre-processing) and after film deposition, the same substrate was subjected to the measurement for calculation of the difference, from which the film thickness was determined.

{Measurement of electric conductivity}

- Apparatus: Nanoscope V + Dimension ICON manufactured by Bruker AXS (Current is also measured at the same time.)
- Sample bias voltage: 5 V
- Measurement range: 20 μm × 20 μm
- Measurement environment: under Ar atmosphere

Probe (cantilever) Number: DDESP-V2 manufactured by Bruker

- Effective area of probe: $3.14159 \times 10^{-14}$ $m^2$

The head end diameter of the measurement probe was under the same conditions.
The contact resistance between the measurement probe and a sample was always constant, or the difference was negligible even if there existed.
The numerical value of the measured electric conductivity is an average of the resulting current values.

{Measurement of resistivity}

In the case where R (all) = Resistance value [Ω] of whole wafer (wafer + organic film) obtained in Example 1, R (a) = Resistance value [Ω] of region having organic film (region having wafer and organic film), and R (b) = Resistance value [Ω] of region having no organic film (region where wafer only is present), the following formula holds:

$$R\ (all) = R\ (a) + R\ (b) \quad \ldots\ (er1)$$

The average current value of the Cu wafer (including no organic film) in Comparative Example 1 was 160 pA. Based on the numerical value, R (b) [Ω] in Comparative Example 1 was determined. Specifically, based on:

$$\text{Voltage } V\ [V] = \text{Current } I\ [pA] \times \text{Resistance}\ [\Omega] \quad \ldots\ (er2)$$

the following formula holds:

$$\text{Sample bias voltage } 5\ [V] = 160\ [pA] \times R\ (b)\ [\Omega]$$

Based on the above, in Comparative Example 1, R (b) [Ω]=1/32. The value was used as R (b) in Examples 1 and 2.
Using the value of R (b) described above, based on the formula (er1), the resistance R (a) in Examples 1 and 2 were calculated, respectively. Further, based on the following formula (er3), the resistivity ρ of the organic film was calculated:

$$R(a) = \rho \times l/S \quad ... \quad (er3)$$

[in the formula: ρ = Resistivity of organic film [Ω × m], l = Film thickness of organic film [nm], S = Effective area of probe [$m^2$]]

In Tables 2 and 3, the measurement conditions and results are shown.

[Table 2]

| | Voltage V [V] | Current I [pA] | R(a) [Ω] | Resistivity ρ [Ω·m] | Organic film thickness l [nm] |
|---|---|---|---|---|---|
| Example 1 | 5 | 40 | $1.1\times10^{8}$ | $3.2\times10^{1}$ | 1.1 |
| Example 2 | 5 | 6 | 6.0x108 | $3.9\times10^{1}$ | 2.6 |
| Example 3 | 5 | 0.1 | $5.0\times10^{1-0}$ | $1.6\times10^{4}$ | 1.0 |
| Comparative Example 1 | 5 | 160 | - | 9.8 (wafer only) | 0 |

Although insulation occurs (electric conductivity becomes 0 pA) with increase of the film thickness, electricity flows in Examples 1 to 3. Also, it has been proved that although a typical organic film has no electric conductivity, the film of the present invention has electric conductivity as shown in Examples 1 to 3.

An organic film was formed on the wafer in Examples 1 to 3, and by further providing another wafer on the organic film, the organic film functioned as the adhesive layer of the present invention. In other words, the layered product of the present invention was thus formed.

Industrial Applicability

With use of the production method of a layered product of the present disclosure, application of the layered product with a first silicon substrate and a second silicon substrate each having an electrically conductive region can be expanded.

Reference Signs List

10, 20: silicon substrate
15, 25: electrically conductive region
15a, 25a: activated region
30, 30A, 30B: adhesive layer
31, 32A, 33A, 32B, 33B, 33C: adhesive part
40, 40A, 40B: layered product
60: void space

## Claims

**1.** A method for producing a layered product including two silicon substrates, comprising:

(a) providing a first silicon substrate having a first electrically conductive region on at least a part of the surface, and a second silicon substrate; and
(b) bonding a surface including the first electrically conductive region of the first silicon substrate to the second silicon substrate with an adhesive layer,

wherein the adhesive layer includes, on a first activated region provided by activating at least a part of the surface including the first electrically conductive region of the first silicon substrate, a first reaction product derived from a first organic material reactable with the first activated region, and
the layered product has electric conductivity.

**2.** The production method according to claim 1, wherein the first electrically conductive region includes a metal.

3. The production method according to claim 2, wherein the metal in the first electrically conductive region is at least one selected from the group consisting of Cu, Co, Fe, Al, W, Ru and Hf.

4. The production method according to any one of claims 1 to 3, wherein the surface of the first electrically conductive region is exposed.

5. The production method according to any one of claims 1 to 3, wherein at least a part of the surface of the first electrically conductive region is in contact with the adhesive layer.

6. The production method according to any one of claims 1 to 5, wherein the adhesive layer includes two or more layers.

7. The production method according to any one of claims 1 to 6,

wherein the first activated region is provided in at least a part of the first electrically conductive region and at least a part of the first silicon substrate;
the first electrically conductive region includes at least one selected from the group consisting of Cu, Co, Fe, Al, W, Ru and Hf;
the adhesive layer is in contact with the first activated region; and
the adhesive layer has a thickness of 5 nm or less.

8. The production method according to any one of claims 1 to 7,

wherein, further, the second silicon substrate has a second electrically conductive region on at least a part of the surface; and
the adhesive layer is provided on a second activated region provided by activating at least a part of the surface of the second silicon substrate on a side of the second electrically conductive region, and includes a second reaction product derived from a second organic material.

9. The production method according to claim 8, wherein the second electrically conductive region includes a metal.

10. The production method according to claim 8 or 9, wherein the metal in the second electrically conductive region is at least one selected from the group consisting of Cu, Co, Fe, Al, W, Ru and Hf.

11. The production method according to any one of claims 8 to 10, wherein the surface of the second electrically conductive region is exposed.

12. The production method according to any one of claims 8 to 11, wherein at least a part of the surface of the second electrically conductive region is in contact with the adhesive layer.

13. The production method according to any one of claims 8 to 12, wherein the distance between the first electrically conductive region and the second electrically conductive region is 5 nm or less.

14. The production method according to any one of claims 1 to 13, wherein the adhesive layer has a thickness of 5 nm or less.

15. The production method according to any one of claims 8 to 14,

wherein the first activated region is provided in at least a part of the first electrically conductive region and at least a part of the first silicon substrate;
the second activated region is provided in at least a part of the second electrically conductive region and at least a part of the second silicon substrate;
the first electrically conductive region and the second electrically conductive region each include at least one selected from the group consisting of Cu, Co, Fe, Al, W, Ru and Hf;
the adhesive layer is in contact with the first activated region and the second activated region; and
the distance between the first electrically conductive region and the second electrically conductive region is 5 nm or less.

16. A layered product comprising:

a first silicon substrate having a first electrically conductive region on at least a part of the surface;
a second silicon substrate located on the side of a surface having the first electrically conductive region of the first silicon substrate; and
an adhesive layer that is located between the first silicon substrate and the second silicon substrate and that bonds the surface having the first electrically conductive region of the first silicon substrate to the second silicon substrate,
wherein there is conductivity between the first silicon substrate and the second silicon substrate.

**17.** The layered product according to claim 16,

wherein the second silicon substrate has a second electrically conductive region on at least a part of the surface, and
the adhesive layer bonds the surface having the first electrically conductive region to the surface having the second electrically conductive region.

**18.** The layered product according to claim 17, wherein the distance between the first electrically conductive region and the second electrically conductive region is 5 nm or less.

**19.** The layered product according to any one of claims 16 to 18, wherein the adhesive layer has a thickness of 5 nm or less.

**20.** The layered product according to any one of claims 16 to 19, wherein the adhesive layer includes two or more layers.

**21.** The layered product according to any one of claims 17 to 20,

wherein the layered product has the first electrically conductive region and the second electrically conductive region;
the distance between the first electrically conductive region and the second electrically conductive region is 5 nm or less; and
the adhesive layer bonds the surface having the first electrically conductive region to the surface having the second electrically conductive region.

**22.** The layered product according to any one of claims 16 to 21, wherein an electric conductivity measured at the adhesive layer provided on the first silicon substrate is in the range of $1.0\times10^{-2}$ to $5.0\times10^{2}$ pA.

**23.** The layered product according to any one of claims 16 to 22, having a resistivity in the range of $1.5\times10^{-8}$ to $2.0\times10^{5}$ $\Omega\cdot m$.

[Fig. 1A]

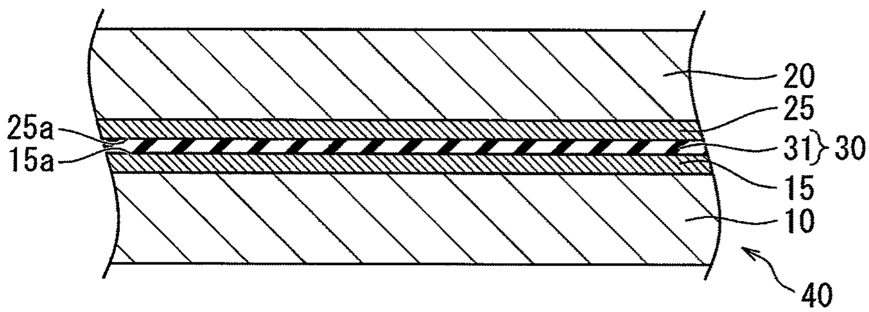


[Fig. 1B]

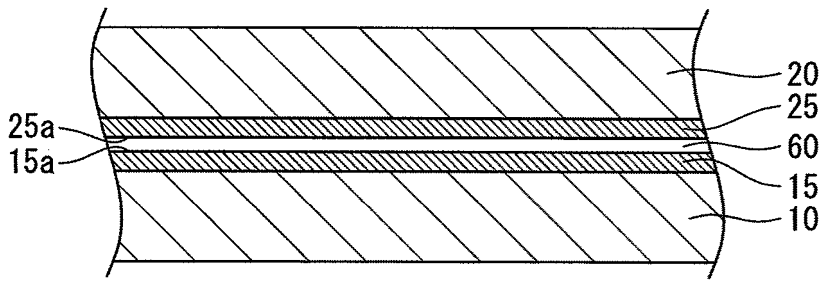

[Fig. 1C]

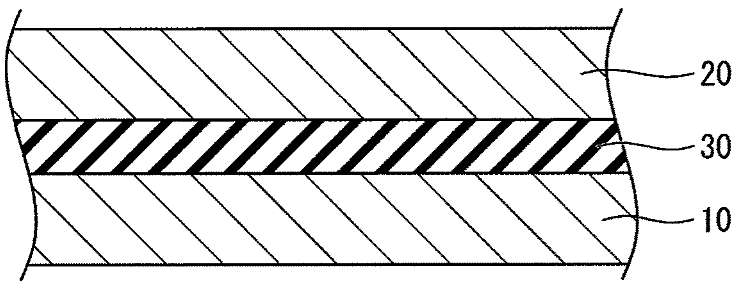


[Fig. 2]

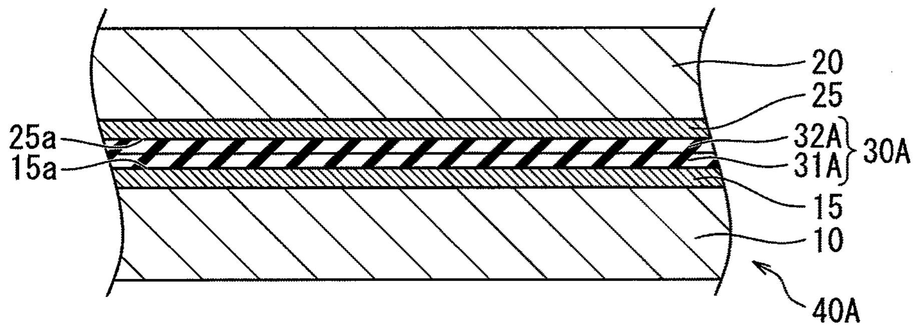

[Fig. 3]

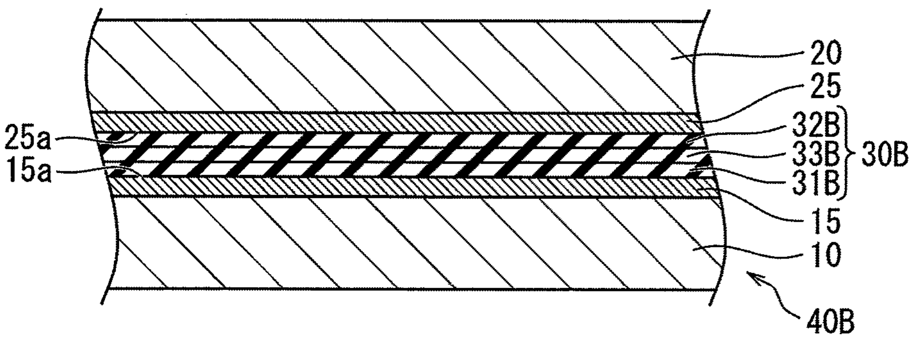

**INTERNATIONAL SEARCH REPORT**

International application No. **PCT/JP2025/008048**

**A. CLASSIFICATION OF SUBJECT MATTER**

***H01L 21/02***(2006.01)i; ***B32B 7/12***(2006.01)i; ***B32B 9/00***(2006.01)i; ***B32B 37/12***(2006.01)i
FI: H01L21/02 B; B32B37/12; B32B7/12; B32B9/00 A

According to International Patent Classification (IPC) or to both national classification and IPC

**B. FIELDS SEARCHED**

Minimum documentation searched (classification system followed by classification symbols)

H01L21/02; B32B7/12; B32B9/00; B32B37/12

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2023/276638 A1 (DAIKIN INDUSTRIES, LTD.) 05 January 2023 (2023-01-05) entire text, all drawings | 1-23 |
| A | JP 2-46722 A (NIPPON SOKEN, INC.) 16 February 1990 (1990-02-16) entire text, all drawings | 1-23 |
| A | JP 2016-119415 A (MITSUBISHI HEAVY INDUSTRIES MACHINE TOOL CO., LTD.) 30 June 2016 (2016-06-30) entire text, all drawings | 1-23 |
| A | JP 2023-99298 A (SEMES CO., LTD.) 12 July 2023 (2023-07-12) entire text, all drawings | 1-23 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **16 May 2025** | **27 May 2025** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2025/008048**

| Patent document cited in search report | Publication date (day/month/year) | Patent family member(s) | Publication date (day/month/year) |
|---|---|---|---|
| WO 2023/276638 A1 | 05 January 2023 | US 2024/0190105 A1<br>entire text, all drawings<br>EP 4362064 A1<br>CN 117529795 A<br>KR 10-2024-0012544 A | |
| JP 2-46722 A | 16 February 1990 | (Family: none) | |
| JP 2016-119415 A | 30 June 2016 | US 2017/0355040 A1<br>entire text, all drawings<br>EP 3240015 A1<br>KR 10-2017-0086619 A<br>CN 107112199 A | |
| JP 2023-99298 A | 12 July 2023 | KR 10-2494936 B1<br>entire text, all drawings<br>CN 116387125 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2023276638 A1